# EUROPEAN PATENT APPLICATION

(11) **EP 2 471 889 A1**
(43) Date of publication of application: **04.07.2012**
(21) Application number: 10811811.8
(22) Date of filing: 23.08.2010
(51) Int. Cl.: C09K 11/06, C08K 5/3492, C08L 65/00, H01L 51/50, C07F 15/00

(54) **METAL COMPLEX COMPOSITION AND COMPLEX POLYMER**

(30) Priority: 27.08.2009 JP 2009197072
(71) Applicant: Sumitomo Chemical Company, Limited, Tokyo 104-8260 (JP); National Institute of Advanced Industrial Science and Technology, Tokyo 100-8921 (JP)
(72) Inventor: KONNO Hideo, Tsukuba-shi Ibaraki 305-8565 (JP); SATO Kazuhiko, Tsukuba-shi Ibaraki 305-8565 (JP); SEKINE Chizu, Tokyo 103-0012 (JP); SOGA Masayuki, Kita-ku, Tokyo 114-0024 (JP)
(74) Representative: Duckworth, Timothy John
(86) International application number: PCT/JP2010/064185
(87) International publication number: WO 2011/024761

(57) **Abstract**

A metal complex composition comprising a metal complex including a structure represented by the following formula (1) and a charge transport material, 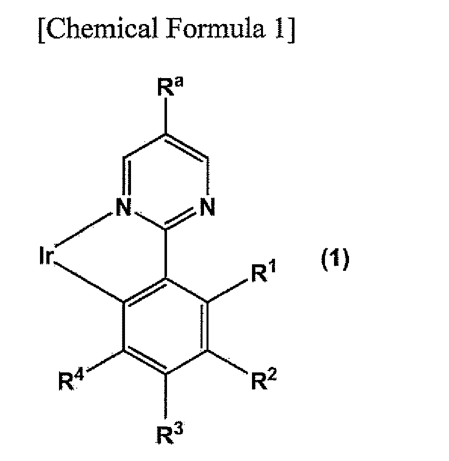 wherein in the formula (1), R^{a} represents an alkyl group having 2 to 30 carbon atoms, and R¹, R², R³ and R⁴ each independently represent a hydrogen atom, an alkyl group having 1 to 30 carbon atoms that may have a substituent, or the like, provided that adjacent groups among R¹, R², R³ and R⁴ may be bonded to each other to form a ring structure.

## Description

### Technical Field

The present invention relates to a metal complex composition and a complex polymer, and a liquid composition, an organic film, an organic electroluminescence device, a planar light source and a display using the metal complex composition or the complex polymer.

### Background Art

Organic electroluminescence devices (also called organic EL devices or organic light-emitting devices) are devices prepared by sandwiching an organic film including a fluorescent organic compound or a phosphorescent organic compound between an anode and a cathode. In organic electroluminescence devices, excitons of a fluorescent organic compound or a phosphorescent organic compound in an organic film are produced by injecting holes and electrons into the organic film from each electrode, and light is emitted when the excitons are returned to the ground state. Examples of such organic electroluminescence devices include those using, as a constituent material, an organic metal complex that has a phenylpyridine ligand, or a phenylpyrimidine ligand having a substituent in the para position to the nitrogen atom coordinately bonded to the central metal (see Patent Literature 1, for example).

### Citation List

### Patent Literature

Patent Literature 1: International Publication WO 2002/02714

### Summary of Invention

### Technical Problem

However, conventional organic electroluminescence devices do not necessarily have sufficient luminous efficiency and are still to be improved for practical use.

Accordingly, an object of the present invention is to provide an organic electroluminescence device having sufficiently high luminous efficiency and a planar light source and a display using the organic electroluminescence device. Another object of the present invention is to provide a metal complex composition and a complex polymer useful for the manufacture of the organic electroluminescence device, and a liquid composition and an organic film using the metal complex composition or the complex polymer.

### Solution to Problem

To achieve the above objects, the present invention provides a metal complex composition comprising a metal complex comprising a structure represented by the following formula (1) and a charge transport material, 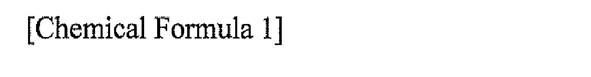 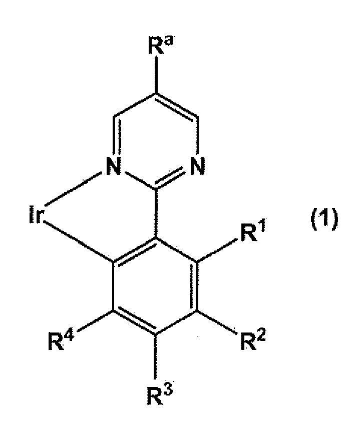 wherein in the formula (1), R^{a} represents an alkyl group having 2 to 30 carbon atoms that may have a substituent, and R¹, R², R³ and R⁴ each independently represent a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, provided that adjacent groups among R¹, R², R³ and R⁴ may be bonded to each other to form a ring structure.

The luminous efficiency and external quantum yield of an organic electroluminescence device can be sufficiently improved by using the above metal complex composition as a constituent material of the organic electroluminescence device. Such an effect is exhibited presumably because the metal complex used in the present invention originally has a high luminous quantum yield in a solution state at room temperature, has a luminous quantum yield in a solid state particularly higher than that of a metal complex in which R^{a} is unsubstituted, has high thermal stability, is soluble in a solvent, and has excellent processability, such that it can sufficiently exhibit its original luminescent properties and it has improved charge injection and charge transport properties by forming a composition with a charge transport material.

In the present invention, a low-molecular-weight organic compound (hereinafter conveniently called "charge transport material (A)") can be suitably used as the above charge transport material.

A polymer compound (hereinafter conveniently called "charge transport material (B)") can also be suitably used as the above charge transport material, where the polymer compound includes at least one constitutional unit selected from the group consisting of a constitutional unit represented by the following formula (2) and a constitutional unit represented by the following formula (3),

[Chemical Formula 2] -Ar¹- (2)

wherein in the formula (2), Ar¹ represents an arylene group, a divalent aromatic heterocyclic group, or a divalent group where two or more identical or different groups selected from the group consisting of the arylene groups and the divalent aromatic heterocyclic groups are directly bonded, provided that a group represented by Ar¹ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, 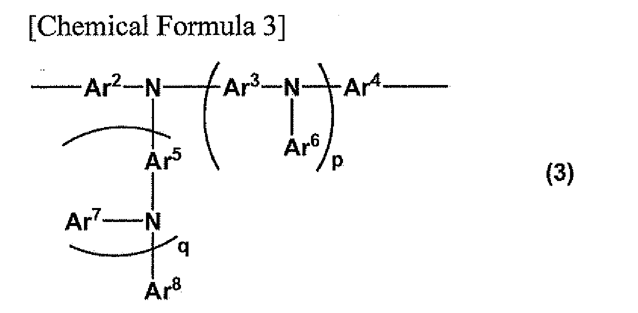 wherein in the formula (3), Ar², Ar³, Ar⁴ and Ar⁵ each independently represent an arylene group, a divalent aromatic heterocyclic group, or a divalent group where two or more identical or different groups selected from the group consisting of the arylene groups and the divalent aromatic heterocyclic groups are directly bonded, Ar⁶, Ar⁷ and Ar⁸ each independently represent an aryl group or a monovalent aromatic heterocyclic group, and p and q are each independently 0 or 1, provided that a group represented by Ar², Ar³, Ar⁴, Ar⁵, Ar⁶, Ar⁷ or Ar⁸ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, respectively, and a group represented by Ar⁵, Ar⁶, Ar⁷ or Ar⁸ may be bonded directly or through -O-, -S-, -C(=O)-, -C(=O)-O-, -N(R^{A})-, -C(=O)-N(R^{A})- or -C(R^{A})₂- to a group represented by Ar², Ar³, . Ar⁴, Ar⁵, Ar⁶, Ar⁷ or Ar⁸ bonded to a nitrogen atom with the group bonded thereto to form a five- to seven-membered ring, respectively, wherein R^{A} represents an alkyl group, an aryl group, a monovalent aromatic heterocyclic group or an aralkyl group.

Further, the above charge transport material (B) preferably includes, as the constitutional unit represented by the above formula (2), a constitutional unit represented by the following formula (4): 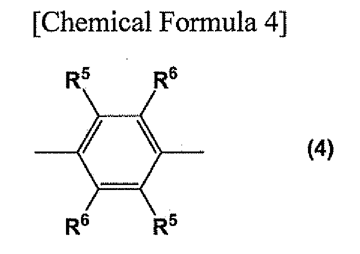 wherein in the formula (4), R⁵ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group or a cyano group, and R⁶ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that two R⁶s may be identical or different, and two R⁵s may be identical or different.

Moreover, the above charge transport material (B) preferably includes, as the constitutional unit represented by the above formula (2), a constitutional unit represented by the following formula (5): 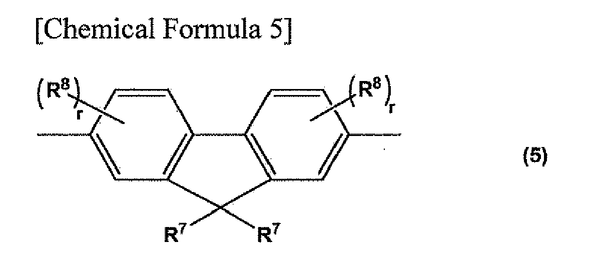 wherein in the formula (5), R⁷ represents an alkyl group, an aryl group, a monovalent aromatic heterocyclic group or an aralkyl group, R⁸ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, and r represents an integer of 0 to 3, provided that two R⁷s may be identical or different, and two R⁷s may be bonded to form a ring structure, that when a plurality of R⁸s are present, the plurality of R⁸s may be identical or different, and that two rs may be identical or different.

The above charge transport material (B) is preferably a conjugated polymer compound.

When the metal complex composition of the present invention comprises the above charge transport material (B), the metal complex composition preferably further comprises an electron transport material having a structure represented by the following formula (6) (hereinafter conveniently called "charge transport material (C)"). Excellent electron injection and electron transport are realized by using the charge transport material (B) and the charge transport material (C) in combination, as a result of which at least either of higher luminous efficiency and low-voltage drive is achieved. 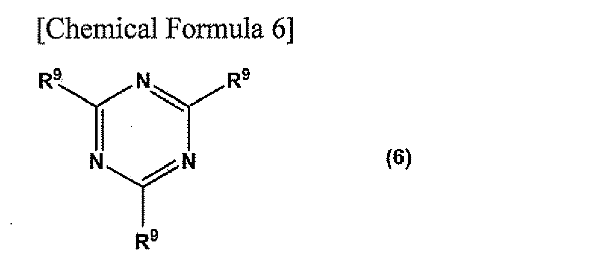 In the formula (6), R⁹ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that three R⁹s may be identical or different.

The present invention also provides a complex polymer comprising a divalent group that is a residue where two hydrogen atoms are removed from a metal complex including a structure represented by the above formula (1) and at least one constitutional unit selected from the group consisting of a constitutional unit represented by the above formula (2) and a constitutional unit represented by the above formula (3).

In other words, the above complex polymer has a constitutional unit derived from a metal complex including a structure represented by the above formula (1) and a constitutional unit derived from the above charge transport material (B), and has an effect similar to that of the metal complex composition of the present invention in which luminous efficiency of an organic electroluminescence device can be sufficiently improved by using the above metal complex composition as a constituent material of the organic electroluminescence device. Further, the complex polymer is also preferred in terms of workability in the manufacture of an organic electroluminescence device.

The present invention also provides a liquid composition comprising the above metal complex composition or complex polymer of the present invention and a solvent.

The present invention also provides an organic film comprising the above metal complex composition or complex polymer of the present invention.

Since the above liquid composition and organic film comprise the metal complex composition or complex polymer of the present invention, they are extremely useful in that the luminous efficiency of an organic electroluminescence device can be sufficiently improved by using them in the manufacture of the organic electroluminescence device.

The present invention also provides an organic electroluminescence device comprising an organic film, the organic electroluminescence device comprising the above metal complex composition or complex polymer of the present invention in the above organic film.

The above organic electroluminescence device can achieve sufficiently high luminous efficiency, because it comprises the metal complex composition or complex polymer of the present invention in the above organic film.

The present invention also provides a planar light source comprising the above organic electroluminescence device of the present invention.

The present invention also provides a display comprising the above organic electroluminescence device of the present invention.

The planar light source and the display of the present invention can achieve sufficiently high luminous efficiency, because they are comprising the organic electroluminescence device of the present invention, respectively.

### Advantageous Effects of Invention

The present invention can provide an organic electroluminescence device having sufficiently high luminous efficiency and a planar light source and a display using the organic electroluminescence device. The present invention can also provide a metal complex composition and a complex polymer useful for the manufacture of the organic electroluminescence device, and a liquid composition and an organic film using the metal complex composition or the complex polymer.

### Description of Embodiments

Preferred embodiments of the present invention will be described in detail below. In the present specification, the "constitutional unit(s)" refer to one or more units present in a polymer compound, and the "constitutional unit(s)" in the present specification are preferably contained in a polymer compound as "repeating units" (i.e., two or more units present in a polymer compound).

### [First embodiment; Metal complex composition]

The metal complex composition according to the first embodiment of the present invention comprises a metal complex including a structure represented by the following formula (1): 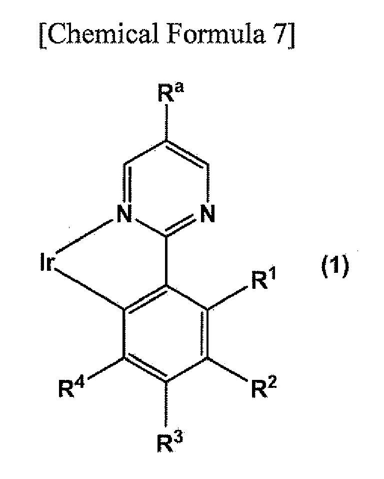 wherein in the formula (1), R^{a} represents an alkyl group having 2 to 30 carbon atoms that may have a substituent, and R¹, R², R³ and R⁴ each independently represent a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, provided that adjacent groups among R¹, R² R³ and R⁴ may be bonded to each other to form a ring structure; and a charge transport material.

First, the metal complex including a structure represented by the above formula (1) will be described in detail.

In the above formula (1), R^{a} is an alkyl group having 2 to 30 (preferably 2 to 20, more preferably 3 to 20, still more preferably 5 to 20, particularly preferably 10 to 20) carbon atoms that may have a substituent.

It is preferred that R^{a} be an alkyl group having 2 to 30 carbon atoms that may have a substituent in terms of synthesis operability and purification operability, and also particularly in terms of fabrication of an organic electroluminescence device using an application process, because solubility of the metal complex in a solvent (such as dichloromethane, chloroform, toluene, tetrahydrofuran or xylene) is drastically improved.

R^{a} will be specifically described below.
Examples of the alkyl group having 2 to 30 carbon atoms that may have a substituent include an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 2-methylpentyl group, a 1-pentylhexyl group, a 1-butylpentyl group, a 1-heptyloctyl group, a 3-methylpentyl group, a 1-hydroxyethyl group, a 2-hydroxyethyl group, a 2-hydroxyisobutyl group, a 1,2-dihydroxyethyl group, a 1,3-dihydroxyisopropyl group, a 2,3-dihydroxy-t-butyl group, a 1,2,3-trihydroxypropyl group, a 1-chloroethyl group, a 2-chloroethyl group, a 2-chloroisobutyl group, a 1,2-dichloroethyl group, a 1,3-dichloroisopropyl group, a 2,3-dichloro-t-butyl group, a 1,2,3-trichloropropyl group, a 1-bromoethyl group, a 2-bromoethyl group, a 2-bromoisobutyl group, a 1,2-dibromoethyl group, a 1,3-dibromoisopropyl group, a 2,3-dibromo-t-butyl group, a 1,2,3-tribromopropyl group, a 1-iodoethyl group, a 2-iodoethyl group, a 2-iodoisobutyl group, a 1,2-diiodoethyl group, a 1,3-diiodoisopropyl group, a 2,3-diiodo-t-butyl group, a 1,2,3-triiodopropyl group, a 1-aminoethyl group, a 2-aminoethyl group, a 2-aminoisobutyl group, a 1,2-diaminoethyl group, a 1,3-diaminoisopropyl group, a 2,3-diamino-t-butyl group, a 1,2,3-triaminopropyl group, a 1-cyanoethyl group, a 2-cyanoethyl group, a 2-cyanoisobutyl group, a 1,2-dicyanoethyl group, a 1,3-dicyanozsopropyl group, a 2,3-dicyano-t-butyl group, a 1,2,3-tricyanopropyl group, a 1-nitroethyl group, a 2-nitroethyl group, a 1,2-dinitroethyl group, a 2,3-dinitro-t-butyl group, a 1,2,3-trinitropropyl group, a cyclopentyl group, a cyclohexyl group, a cyclooctyl group and a 3,5-tetramethylcyclohexyl group. Preferred groups among these are an ethyl group, a propyl group, an isopropyl group, an n-butyl group, an s-butyl group, an isobutyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, a neopentyl group, a 1-methylpentyl group, a 1-pentylhexyl group, a 1-butylpentyl group, a 1-heptyloctyl group, a cyclohexyl group, a cyclooctyl group and a 3,5-tetramethylcyclohexyl group.

In the above formula (1), R¹, R², R³ and R⁴ each independently represent a hydrogen atom, an alkyl group having 1 to 30 (preferably 1 to 20, more preferably 1 to 15, still more preferably 1 to 10, particularly preferably 1 to 5) carbon atoms that may have a substituent, an aryl group having 6 to 60 (preferably 6 to 30, more preferably 6 to 20, still more preferably 6 to 15, particularly preferably 6 to 12) carbon atoms that may have a substituent, an alkenyl group having 2 to 30 (preferably 2 to 20, more preferably 2 to 15, still more preferably 2 to 10) carbon atoms that may have a substituent, an alkynyl group having 2 to 30 (preferably 2 to 20, more preferably 2 to 10) carbon atoms that may have a substituent, an amino group having 0 to 30 (preferably 0 to 20, more preferably 0 to 10) carbon atoms that may have a substituent, a monovalent heterocyclic group having 1 to 60 (preferably 1 to 30, more preferably 1 to 20, particularly preferably 1 to 12) carbon atoms that may have a substituent, an alkoxy group having 1 to 30 (preferably 1 to 20, more preferably 1 to 10) carbon atoms that may have a substituent, an alkylthio group having 1 to 30 (preferably 1 to 20, more preferably 1 to 10) carbon atoms that may have a substituent, an aryloxy group having 6 to 60 (preferably 6 to 30, more preferably 6 to 20, still more preferably 6 to 15, particularly preferably 6 to 12) carbon atoms that may have a substituent, an arylthio group having 6 to 60 (preferably 6 to 30, more preferably 6 to 20, still more preferably 6 to 15, particularly preferably 6 to 12) carbon atoms that may have a substituent, a heterocyclic oxy group having 1 to 60 (preferably 1 to 30, more preferably 1 to 20, still more preferably 1 to 12) carbon atoms that may have a substituent, a heterocyclic thio group having 1 to 60 (preferably 1 to 30, more preferably 1 to 20, still more preferably 1 to 12) carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom (preferably a chlorine atom, a bromine atom or a fluorine atom, more preferably a fluorine atom), a cyano group, a carboxyl group or a trifluoromethyl group. Representative groups among groups represented by R¹, R², R³ or R⁴ will be described below.

Examples of the alkyl group having 1 to 30 carbon atoms that may have a substituent include a methyl group and alkyl groups having 2 to 3 0 carbon atoms which are illustrated in the description of R^{a}.

Examples of the aryl group having 6 to 60 carbon atoms that may have a substituent include a phenyl group, a biphenyl-2-yl group, a biphenyl-3-yl group, a biphenyl-4-yl group, a p-terphenyl-4-yl group, a p-terphenyl-3-yl group, a p-terphenyl-2-yl group, an m-terphenyl-4-yl group, an m-terphenyl-3-yl group, an m-terphenyl-2-yl group, an o-tolyl group, an m-tolyl group, a p-tolyl group, a p-t-butylphenyl group, a p-(2-phenylpropyl)phenyl group, a 4'-methylbiphenylyl group, a 4"-t-butyl-p-terphenyl-4-yl group, an o-cumenyl group, an m-cumenyl group, a p-cumenyl group, a 2,3-xylyl group, a 3,4-xylyl group, a 2,5-xylyl group, a mesityl group, an m-quaterphenyl group, a 1-naphthyl group and a 2-naphthyl group. Preferred groups among these are a phenyl group, a biphenyl-2-yl group, a biphenyl-3-yl group, a biphenyl-4-yl group, an m-terphenyl-4-yl group, an m-terphenyl-3-yl group, an m-terphenyl-2-yl group, a p-tolyl group, a 3,4-xylyl group and an m-quaterphenyl-2-yl group, with a phenyl group being particularly preferred. These aryl groups may have a substituent. Further examples include groups described in Japanese Patent Application Laid-Open Publication No. 2009-149617 and represented by the following formulas.

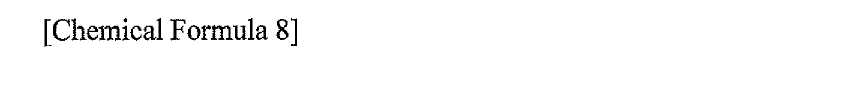

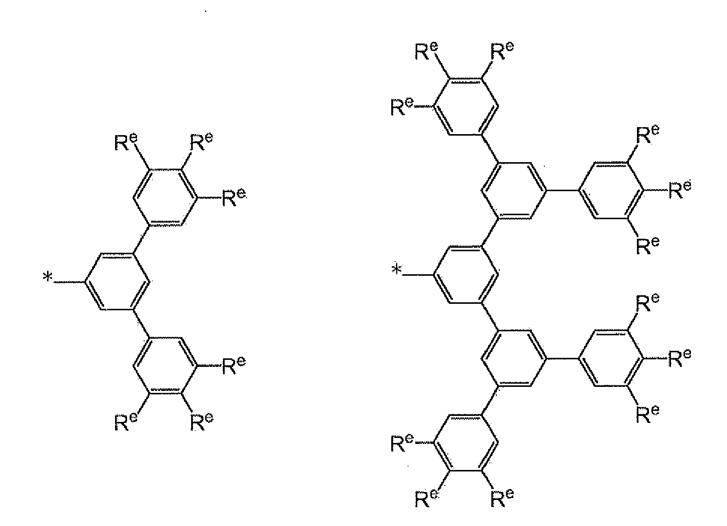

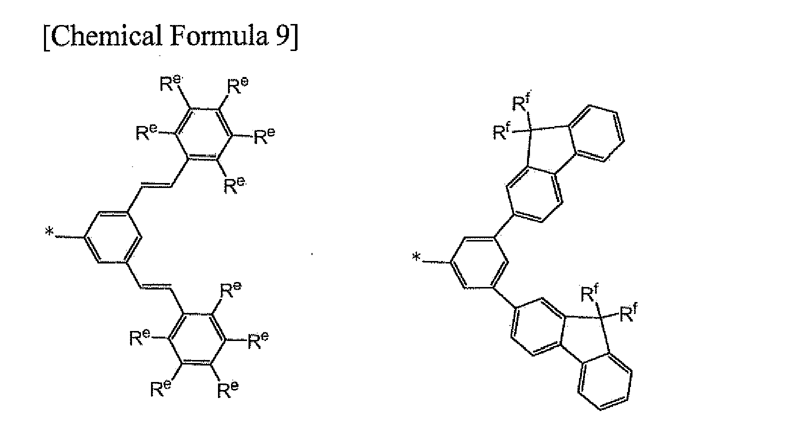

In the above formulas, R^{e} represents a hydrogen atom, an alkyl group having 1 to 10 carbon atoms or an alkoxy group having 1 to 10 carbon atoms, and some of the hydrogen atoms of these substituents may be replaced with a halogen atom. Although a plurality of R^{e}s present may be identical or different, at least one of R^{e}s is an alkyl group having 1 to 10 carbon atoms or an alkoxy group having 1 to 10 carbon atoms. R^{f} represents a linear or branched alkyl group having 1 to 10 carbon atoms. A plurality of R^{f}s present may be identical or different. * represents a bond.

Examples of the alkenyl group having 2 to 30 carbon atoms that may have a substituent include a vinyl group, an allyl group, a 1-butenyl group, a 2-butenyl group, a 3-butenyl group, a 1,3-butanedienyl group, a 1-methylvinyl group, a styryl group, a 2,2-diphenylvinyl group, a 1,2-diphenylvinyl group, a 1-methylallyl group, a 1,1-dimethylallyl group, a 2-methylallyl group, a 1-phenylallyl group, a 2-phenylallyl group, a 3-phenylallyl group, a 3,3-diphenylallyl group, a 1,2-dimethylallyl group, a 1-phcnyl-1-butenyl group and a 3-phenyl-1-butenyl group, with a styryl group, a 2,2-diphenylvinyl group and a 1,2-diphenylvinyl group being preferred.

Examples of the alkynyl group having 2 to 30 carbon atoms that may have a substituent include a propargyl group, a 3-pentynyl group, an ethynyl group, a methylethynyl group, a 1-propynyl group, a 2-propylenyl group, a heptynyl group, a cyclohexylethynyl group, a 2-propynyl group, a 1-butynyl group, a 2-butynyl group, a 1-pentynyl group, a 2-pentynyl group, a 1-hexynyl group, a 2-hexynyl group and a 1-octynyl group. Such alkynyl groups also include diynyl groups such as a 1,3-butadiynyl group.

Examples of the amino group having 0 to 30 carbon atoms that may have a substituent include an amino group (-NH₂), a dibenzylamino group, a ditolylamino group, a methylamino group, a dimethylamino group, an ethylamino group, a diethylamino group, an n-propylamino group, a di-n-propylamino group, an isopropylamino group, a diisopropylamino group, an n-butylamino group, an s-butylamino group, an isobutylamino group, a t-butylamino group, an n-pentylamino group, an n-hexylamino group, a cyclohexylamino group, an n-heptylamino group, an n-octylamino group, a 2-ethylhexylamino group, an n-nonylamino group, an n-decylamino group, a 3,7-dimethyloctylamino group, an n-laurylamino group, a cyclopentylamino group, a dicyclopentylamino group, a cyclohexylamino group, a dicyclohexylamino group, a pyrrolidinyl group, a piperidinyl group, a ditrifluoromethylamino group, a phenylamino group, a diphenylamino group, a C₁-C₁₂ alkoxyphenylamino group ("C₁-C₁₂ alkoxy" indicates that the alkoxy moiety has 1 to 12 carbon atoms; hereinafter the same), a di(C₁-C₁₂ alkoxyphenyl)amino group, a di(C₁-C₁₂ alkylphenyl)amino group ("C₁-C₁₂ alkyl" indicates that the alkyl moiety has 1 to 12 carbon atoms; hereinafter the same), a 1-naphthylamino group, a 2-naphthylamino group, a pentafluorophenylamino group, a pyridinylamino group, a pyridazinylamino group, a pyrimidinylamino group, a pyrazinylamino group, a triazinylamino group, a phenyl-C₁-C₁₂ alkylamino group, a C₁-C₁₂ alkoxyphenyl-C₁-C₁₂ alkylamino group, a C₁-C₁₂ alkylphenyl-C₁-C₁₂ alkylamino group, a di(C₁-C₁₂ alkoxyphenyl-C₁-C₁₂ alkyl)amino group, a di(C₁-C₁₂ alkylphenyl-C₁-C₁₂ alkyl)amino group, a 1-naphthyl-C₁-C₁₂ alkylamino group and a 2-naphthyl-C₁-C₁₂ alkylamino group.

The monovalent heterocyclic group having 1 to 60 carbon atoms that may have a substituent is a residue in which one hydrogen atom is removed from a heterocyclic compound; it includes one having a fused ring, but is preferably a monovalent aromatic heterocyclic group. Examples of the monovalent heterocyclic group having 1 to 60 carbon atoms that may have a substituent include a 1-pyrrolyl group, a 2-pyrrolyl group, a 3-pyrrolyl group, a pyrazinyl group, a 2-pyridinyl group, a 1-imidazolyl group, a 2-imidazolyl group, a 1-pyrazolyl group, a 1-indolizinyl group, a 2-indolizinyl group, a 3-indolizinyl group, a 5-indolizinyl group, a 6-indolizinyl group, a 7-indolizinyl group, a 8-indolizinyl group, a 2-imidazopyridinyl group, a 3-imidazopyridinyl group, a 5-imidazopyridinyl group, a 6-imidazopyridinyl group, a 7-imidazopyridinyl group, a 8-imidazopyridinyl group, a 3-pyridinyl group, a 4-pyridinyl group, a 1-indolyl group, a 2-indolyl group, a 3-indolyl group, a 4-indolyl group, a 5-indolyl group, a 6-indolyl group, a 7-indolyl group, a 1-isoindolyl group, a 2-isoindolyl group, a 3-isoindolyl group, a 4-isoindolyl group, a 5-isoindolyl group, a 6-isoindolyl group, a 7-isoindolyl group, a 2-furyl group, a 3-furyl group, a 2-benzofuranyl group, a 3-benzofuranyl group, a 4-benzofuranyl group, a 5-benzofuranyl group, a 6-benzofuranyl group, a 7-benzofuranyl group, a 1-isobenzofuranyl group, a 3-isobenzofuranyl group, a 4-isobenzofuranyl group, a 5-isobenzofuranyl group, a 6-isobenzofuranyl group, a 7-isobenzofuranyl group, a 2-quinolyl group, a 3-quinolyl group, a 4-quinolyl group, a 5-quinolyl group, a 6-quinolyl group, a 7-quinolyl group, a 8-quinolyl group, a 1-isoquinolyl group, a 3-isoquinolyl group, a 4-isoquinolyl group, a 5-isoquinolyl group, a 6-isoquinolyl group, a 7-isoquinolyl group, a 8-isoquinolyl group, a 2-quinoxalinyl group, a 5-quinoxalinyl group, a 6-quinoxalinyl group, a 1-carbazolyl group, a 2-carbazolyl group, a 3-carbazolyl group, a 4-carbazolyl group, a 9-carbazolyl group, a β-carbolin-1-yl group, a β-carboln-3-yl group, a β-carbolin-4-yl group, a β-carbolzn-5-yl group, a β-carbolin-6-yl group, a β-carbolin-7-yl group, a β-carbolin-6-yl group, a β-carbolin-9-yl group, a 1-phenanthridinyl group, a 2-phenanthridinyl group, a 3-phenanthridinyl group, a 4-phenanthridinyl group, a 6-phenanthridinyl group, a 7-phenanthridinyl group, a 8-phenanthridinyl group, a 9-phenanthridinyl group, a 10-phenanthridinyl group, a 1-acridinyl group, a 2-acridinyl group, a 3-acridinyl group, a 4-acridinyl group, a 9-acridinyl group, a 1,7-phenanthrolin-2-yl group, a 1,7-phenanthrolin-3-yl group, a 1,7-phenanthrolin-4-yl group, a 1,7-phenanthrolin-5-yl group, a 1,7-phenanthrolin-6-yl group, a 1,7-phenanthrolin-8-yl group, a 1,7-phenanthrolin-9-yl group, a 1,7-phenanthrolin-10-yl group, a 1,8-phenanthrolin-2-yl group, a 1,8-phenanthrolin-3-yl group, a 1,8-phenanthrolin-4-yl group, a 1,8-phenanthrolin-5-yl group, a 1,8-phenanthrolin-6-yl group, a 1,8-phenanthrolin-7-yl group, a 1 8-phenanthrolin-9-yl group, a 1,8-phenanthrolin-lO-yl group, a 1,9-phenanthrolin-2-yl group, a 1,9-phenanthrolin-3-yl group, a 1,9-phenanthrolin-4-yl group, a 1,9-phenanthrolin-5-yl group, a 1,9-phenanthrolin-6-yl group, a 1,9-phenanthrolin-7-yl group, a 1,9-phenanthrolin-8-yl group, a 1,9-phenanthrolin-I4-yl group, a 1,10-phenanthrolin-2-yl group, a 1,10-phenanthrolin-3-yl group, a 1,10-phenanthrolin-4-yl group, a 1,10-phenanthrolin-5-yl group, a 2,9-phenanthrolin-1-yl group, a 2,9-phenanthrolin-3-yl group, a 2,9-phenantbrolin-4-yl group, a 2,9-phenanthrolin-5-yl group, a 2,9-phenanthrolin-6-yl group, a 2,9-phenanthrolin-7-yl group, a 2,9-phenanthrolin-8-yl group, a 2,9-phenanthrolin-10-yl group, a 2,8-phenanthrolin-1-yl group, a 2,8-phenanthrolin-3-yl group, a 2,8-phenanthrolin-4-yl group, a 2,8-phenanthrolin-5-yl group, a 2,8-phenanthrolin-6-yl group, a 2,8-phenanthrolin-7-yl group, a 2,8-phenanthrolin-9-yl group, a 2,8-phenanthrolin-10-yl group, a 2,7-phenanthrolin-1-yl group, a 2,7-phenanthrolin-3-yl group, a 2,7-phenanthrolin-4-yl group, a 2,7-phenanthrolin-5-yl group, a 2,7-phenanthrolin-6-yl group, a 2,7-phenanthrolin-8-yl group, a 2,7-phenanthrolin-9-yl group, a 2,7-phenanthrolin-10-yl group, a 1-phenazinyl group, a 2-phenazinyl group, a 1-phenothiazinyl group, a 2-phenothiazinyl group, a 3-phenothiazinyl group, a 4-phenothiazinyl group, a 10-phenothiazinyl group, a 1-phenoxazinyl group, a 2-phenoxazinyl group, a 3-phenoxazinyl group, a 4-phenoxazinyl group, a 10-phenoxazinyl group, a 2-oxazolyl group, a 4-oxazolyl group, a 5-oxazolyl group, a 2-oxadiazolyl group, a 5-oxadiazolyl group, a 3-furazanyl group, a 2-thienyl group, a 3-thienyl group, a 2-methylpyrrol-1-yl group, a 2-methylpyrrol-1-yl group, a 2-methylpyrrol-4-yl group, a 2-methylpyrrol-5-yl group, a 3-methylpyrrol-1-yl group, a 3-methylpyrrol-2-yl group, a 3-methylpyrrol-4-yl group, a 3-methylpyrrol-5-yl group, a 2-t-butylpyrrol-4-yl group, a 3-(2-phenylpropyl)pyrrol-1-yl group, a 2-methyl-1-indolyl group, a 4-methyl-1-indolyl group, a 2-methyl-3-indolyl group, a 4-methyl-3-indolyl group, a 2-t-butyl-1-indolyl group, a 4-t-butyl-1-indolyl group, a 2-t-butyl-3-indolyl group, a 4-t-butyl-3-indolyl group, a 1-dibenzofuranyl group, a 2-dibenzofuranyl group, a 3-dibenzofuranyl group, a 4-dibenzofuranyl group, a 1-dibenzothiophenyl group, a 2-dibenzothiophenyl group, a 3-dibenzothiophenyl group, a 4-dibenzothiophenyl group, a 1-silafhiorenyl group, a 2-silafluorenyl group, a 3-silafluorenyl group, a 4-silafluorenyl group, a 1-germafluorenyl group, a 2-germafluorenyl group, a 3-germafluorenyl group and a 4-germafluorenyl group. Preferred groups among these include a 2-pyridinyl group, a 1-indolizinyl group, a 2-indolizinyl group, a 3-indolizinyl group, a 5-indolizinyl group, a 6-indolizinyl group, a 7-indolizinyl group, a 8-indolizinyl group, a 2-imidazopyridinyl group, a 3-imidazopyridinyl group, a 5-imidazopyridinyl group, a 6-imidazopyridinyl group, a 7-imidazopyridinyl group, a 8-imidazopyridinyl group, a 3-pyridinyl group, a 4-pyridinyl group, a 1-indolyl group, a 2-indolyl group, a 3-indolyl group, a 4-indolyl group, a 5-indolyl group, a 6-indolyl group, a 7-indolyl group, a 1-isoindolyl group, a 2-isoindolyl group, a 3-isoindolyl group, a 4-isoindolyl group, a 5-isoindolyl group, a 6-isoindolyl group, a 7-isoindolyl group, a 1-carbazolyl group, a 2-carbazolyl group, a 3-carbazolyl group, a 4-carbazolyl group, a 9-carbazolyl group, a 1-dibenzofuranyl group, a 2-dibenzofuranyl group, a 3-dibenzofuranyl group, a 4-dibenzofuranyl group, a 1-dibenzothiophenyl group, a 2-dibenzothiophenyl group, a 3-dibenzothiophenyl group, a 4-dibenzothiophenyl group, a 1-silafluorenyl group, a 2-silafluorenyl group, a 3-silafluorenyl group, a 4-silafluorenyl group, a 1-germafluorenyl group, a 2-germafl.uorenyl group, a 3-germafluorenyl group and a 4-germafluorenyl group.

The alkoxy group having 1 to 30 carbon atoms that may have a substituent or the alkylthio group having 1 to 30 carbon atoms that may have a substituent is a group represented by -OY or -SY (where Y represents an alkyl group having 1 to 30 carbon atoms that may have a substituent).
Examples of Y include a methyl group, an ethyl group, a propyl group, an isopropyl group, an n-butyl group, an s-butyl group, an isobutyl group, a t-butyl group, an n-pentyl group, an n-hexyl group, an n-heptyl group, an n-octyl group, a hydroxymethyl group, a 1-hydroxyethyl group, a 2-hydroxyethyl group, a 2-hydroxyisobutyl group, a 1,2-dihydroxyethyl group, a 1,3-dihydroxyisopropyl group, a 2,3-dihydroxy-t-butyl group, a 1,2,3-trihydroxypropyl group, a chloromethyl group, a 1-chloroethyl group, a 2-chloroethyl group, a 2-chloroisobutyl group, a 1,2-dichloroethyl group, a 1,3-dichloroisopropyl group, a 2,3-dichloro-t-butyl group, a 1,2,3-trichloropropyl group, a bromomethyl group, a 1-bromoethyl group, a 2-bromoethyl group, a 2-bromoisobutyl group, a 1,2-dibromoethyl group, a 1,3-dibromoisopropyl group, a 2,3-dibramo-t-butyl group, a 1,2,3-tribromopropyl group, an iodomethyl group, a 1-iodoethyl group, a 2-iodoethyl group, a 2-iodoisobutyl group, a 1,2-diiodoethyl group, a 1,3-diiodoisopropyl group, a 2,3-diiodo-t-butyl group, a 1,2,3-triiodopropyl group, an aminomethyl group, a 1-aminoethyl group, a 2-aminoethyl group, a 2-aminoisobutyl group, a 1,2-diaminoethyl group, a 1,3-diaminoisopropyl group, a 2,3-diamino-t-butyl group, a 1,2,3-triaminopropyl group, a cyanomethyl group, a 1-cyanoethyl group, a 2-cyanoethyl group, a 2-cyanoisobutyl group, a 1,2-dicyanoethyl group, a 1,3-dicyanoisopropyl group, a 2,3-dicyano-t-butyl group, a 1,2,3-tricyanopropyl group, a nitromethyl group, a 1-nitroethyl group, a 2-nitroethyl group, a 2-nitroisobutyl group, a 1,2-dinitroethyl group, a 1,3-dinitroisopropyl group, a 2,3-dinitro-t-butyl group and a 1,2,3-trinitropropyl group.

The aryloxy group having 6 to 60 carbon atoms that may have a substituent or the arylthio group having 6 to 60 carbon atoms that may have a substituent is a group represented by -OZ or -SZ (where Z represents an aryl group having 6 to 60 carbon atoms that may have a substituent).
Examples of Z include a phenyl group, a C₁-C₁₂ alkoxyphenyl group, a C₁-C₁₂ alkylphenyl group, a 1-naphthyl group, a 2-naphthyl group and a pentafluorophenyl group.

The heterocyclic oxy group having 1 to 60 carbon atoms that may have a substituent or the heterocyclic thio group having 1 to 60 carbon atoms that may have a substituent is a group represented by -OHet or -SHet (where Het represents a monovalent heterocyclic group having 1 to 60 carbon atoms that may have a substituent).
Examples of Het include a thienyl group, a C₁-C₁₂ alkoxythienyl group, a C₁-C₁₂ alkylthienyl group, a pyrrolyl group, a C₁-C₁₂ alkoxypyrrolyl group, a C₁-C₁₂ alkylpyrrolyl group, a furyl group, a C₁-C₁₂ alkoxyfuryl group, a C₁-C₁₂ alkylfuryl group, a pyridinyl group, a C₁-C₁₂ alkoxypyridinyl group, a C₁-C₁₂ alkylpyridinyl group, a piperidinyl group, a C₁-C₁₂ alkoxypiperidinyl group, a C₁-C₁₂ alkylpiperidinyl group, a quinolyl group and an isoquinolyl group, with a C₁-C₁₂ alkoxy pyridinyl group and a C₁-C₁₂ alkylpyridinyl group being preferred.

The above acyl group has usually 2 to 20, preferably 2 to 18, carbon atoms. Specific acyl groups include an acetyl group, a propionyl group, a butyryl group, an isobutyryl group, a pivaloyl group, a benzoyl group, a trifluoroacetyl group and a pentafluorobenzoyl group.

The above acyloxy group has usually 2 to 20, preferably 2 to 18, carbon atoms. Specific acyloxy groups include an acetoxy group, a propionyloxy group, a butyryloxy group, an isobutyryloxy group, a pivaloyloxy group, a benzoyloxy group, a trifluoroacetyloxy group and a pentafluorobenzoyloxy group.

Examples of the above substituted silyl group, substituted silyloxy group, substituted silylthio group or substituted silylamino group include groups whose substituted silyl moiety is a triethylsilyl group, a triisopropylsilyl group, a t-butyldimethylsilyl group or a t-butyldiphenylsilyl group.

When the above R^{a} is an alkyl group and R¹, R², R³ and R⁴ are each an alkyl group, an aryl group, an alkenyl group, an alkynyl group, an amino group, a monovalent heterocyclic group, an alkoxy group, an alkylthio group, an aryloxy group, an arylthio group, a heterocyclic oxy group or a heterocyclic thio group, examples of the substituent that may be possessed by each group include, in addition to the groups described above, alkyl groups such as a methyl group, an ethyl group, a propyl group and a t-butyl group, aralkyl groups such as a benzyl group and a phenethyl group, alkoxy groups such as a methoxy group, an ethoxy group and a propoxy group, aryl groups such as a phenyl group and a biphenyl group, monovalent heterocyclic groups such as a thienyl group, a pyrrolyl group and a pyridinyl group, aryloxy groups such as a phenoxy group, substituted amino groups such as a dimethylamino group, a diethylamino group, a dibenzylamino group, a diphenylamino group, a ditolylamino group and a dianisolylamino group, and a cyano group.

R¹ is preferably a hydrogen atom, a halogen atom, an aryl group having 6 to 30 carbon atoms that may have a substituent, or an alkyl group having 1 to 20 carbon atoms that may have a substituent, more preferably a hydrogen atom, a fluorine atom, an aryl group having 6 to 12 carbon atoms that may have a substituent, or an alkyl group having 1 to 10 carbon atoms that may have a substituent, still more preferably a hydrogen atom or a fluorine atom, among the above groups.

R² is preferably a hydrogen atom, a halogen atom, a trifluoromethyl group, a cyano group, an aryl group having 6 to 30 carbon atoms that may have a substituent, or an alkyl group having 1 to 20 carbon atoms that may have a substituent, more preferably a hydrogen atom, a trifluoromethyl group, an aryl group having 6 to 12 carbon atoms that may have a substituent, or an alkyl group having 1 to 10 carbon atoms that may have a substituent, among the above groups.

R³ is preferably a hydrogen atom, a halogen atom, an aryl group having 6 to 20 carbon atoms that may have a substituent, or an alkyl group having 1 to 20 carbon atoms that may have a substituent, more preferably a hydrogen atom, a fluorine atom, an aryl group having 6 to 12 carbon atoms that may have a substituent, or an alkyl group having 1 to 10 carbon atoms that may have a substituent, among the above groups.

R⁴ is preferably a hydrogen atom, a trifluoromethyl group, or an alkyl group having 1 to 10 carbon atoms that may have a substituent, more preferably a hydrogen atom or an alkyl group having 1 to 5 carbon atoms that may have a substituent, still more preferably a hydrogen atom, among the above groups.

It is also preferred that adjacent groups among R¹ R², R³ and R⁴ be bonded to each other to form a saturated or unsaturated hydrocarbon ring or a saturated or unsaturated heterocycle.

When R² is an aryl group having 6 to 30 carbon atoms that may have a substituent, it is also preferred to form a dendrimer structure described in National Publication of International Patent Application No. 2005-521210, National Publication of International Patent Application No. 2005-537321, National Publication of International Patent Application No. 2005-537354, Japanese Patent Application Laid-Open Publication No. 2008-174499 or National Publication of International Patent Application No. 2008-538742.

The structure represented by the above formula (1) is a partial structure of a metal complex. The whole structure of the metal complex according to the present embodiment may include a structure represented by the above formula (1), but is preferably a structure represented by the following formula (7): 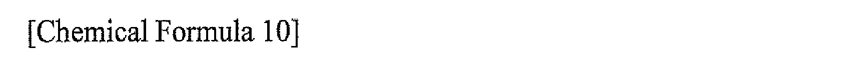 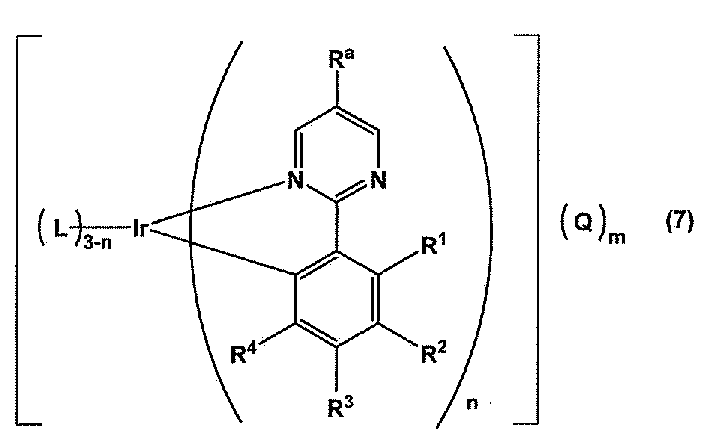 wherein in the formula (7), R^{a} represents an alkyl group having 2 to 30 carbon atoms that may have a substituent, R¹, R², R³ and R⁴ each independently represent a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a monovalent heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, L represents a bidentate ligand, Q represents a counterion, n represents an integer of 1 to 3, and m represents an integer of 0 to 2, provided that adjacent groups among R¹, R², R³ and R⁴ may be bonded to each other to form a ring structure, that two Ls may be identical or different when n is 1, and that two Qs may be identical or different when m is 2.

Since the definitions and illustrations of R^{a}, R¹, R², R³ and R⁴ in the above formula (7) are the same as those of ^{R}a, R¹, R², R³ and R⁴ in the formula (1), respectively, a repeated description is omitted here.

n represents an integer of 1 to 3, and is preferably 2 or 3. When n is 3, facial and meridional isomers are possible as geometric isomers, but facial isomers are preferred.

L is a bidentate ligand. The bidentate ligand is preferably a neutral bidentate ligand or an anionic bidentate ligand, more preferably an anionic bidentate ligand, particularly preferably a monoanionic bidentate ligand.

L is preferably a bidentate ligand forming a metal-nitrogen bond and a metal-carbon bond, a bidentate ligand forming a metal-nitrogen bond and a metal-oxygen bond, a bidentate ligand forming two metal-oxygen bonds, or a bidentate ligand forming two metal-nitrogen bonds between L and an iridium atom.

Examples of the bidentate ligand forming a metal-nitrogen bond and a metal-carbon bond include a 2-phenylpyridine derivative, a 2-phenylpyrimidine derivative, a 2-phenylquinoline derivative, a 1-phenylisoquinoline derivative, a 3-phenylisoquinoline derivative, a 2-(2-benzothiophenyl)pyridine derivative, a 2-thienylpyridine derivative, a 1-phenylpyrazole derivative, a 1-phenyl-1H-indazole derivative, a 2-phenylbenzothiazole derivative, a 2-phenylthiazole derivative, a 2-phenylbenzoxazole derivative, a 2-phenyloxazole derivative, a 2-furanylpyridine derivative, a 2-(2-benzofuranyl)pyridine derivative, a 7,8-benzoquinoline derivative, a 7,8-benzoquinoxaline derivative, a dibenzo[f,h]quinoline derivative, a dibenzo[f,h]quinoxalzne derivative, a benzo[h]-5,6-dihydroquinoline derivative, a 9-(2-pyridyl)carbazole derivative, a 1-(2-pyridyl)indole derivative, a 1-(1-naphthyl)isoquinoline derivative, a 1-(2-naphthyl)isoquinoline derivative, a 2-(2-naphthyl)quinoline derivative, a 2-(1-naphthyl)quinoline derivative, a 3-(1-naphthyl)isoquinoline derivative, a 3-(2-naphthyl)isoquinoline derivative, a 2-(1-naphthyl)pyridine derivative, a 2-(2-naphthyl)pyridine derivative, a 6-phenylphenanthridine derivative, a 6-(1-naphthyl)phenanthrzdine derivative, a 6-(2-naphthyl)phenanthridine derivative, a benzo[c]acridine derivative, a benzo[c]phenazine derivative, a dibenzo[a,c]aeridine derivative, a dibenzo[a,c]phenazine derivative, a 2-phenylqumoxaline derivative, a 2,3-diphenylquinoxaline derivative, a 2-benzylpyridine derivative, a 2-phenylbenzimidazole derivative, a 3-phenylpyrazole derivative, a 4-phenylimidazole derivative, a 1-phenylimidazole derivative, a 4-phenyltriazole derivative, a 5-phenyltetrazole derivative and a 2-alkenylpyridine derivative, with a 2-phenylpyridine derivative, a 2-phenylpyrimidine derivative, a 2-phenylquinoline derivative and a 1-phenylisoquinoline derivative being preferred.

Bidentate ligands forming a metal-nitrogen bond and a metal-carbon bond are described in International Publication WO 2004/085450, International Publication WO 2006/075905, International Publication WO 2002/44189, International Publication WO 2002/45466, International Publication WO 2006/046980, International Publication WO 2006/059758, Japanese Patent Application Laid-Open Publication No. 2006-182772, Japanese Patent Application Laid-Open Publication No. 2006-151888, Japanese Patent Application Laid-Open Publication No. 2006-151887, Japanese Patent Application Laid-Open Publication No. 2006-93665, Japanese Patent Application Laid-Open Publication No. 2006-100393, International Publication WO 2004/101707, International Publication WO 2005/073339, International Publication WO 2005/056719, International Publication WO 2005/056716, International Publication WO 2005/056715, International Publication WO 2005/048315, International Publication WO 2005/033244, International Publication WO 2004/081019, International Publication WO 2004/045000, International Publication WO 2004/044089, International Publication WO 2004/026886, Japanese Patent Application Laid-Open Publication No. 2002-234894, Japanese Patent Application Laid-Open Publication No. 2002-226495, Japanese Patent Application Laid-Open Publication No. 2003-59667, Japanese Patent Application Laid-Open Publication No. 2001-345183, Japanese Patent Application Laid-Open Publication No. 2001-247859, Japanese Patent Application Laid-Open Publication No. 2003-7469, Japanese Patent Application Laid-Open Publication No. 2003-73388, Japanese Patent Application Laid-Open Publication No. 2003-109758, Japanese Patent Application Laid-Open Publication No. 2003-123982, Japanese Patent Application Laid-Open Publication No. 2003-133074, Japanese Patent Application Laid-Open Publication No. 2003-131464, Japanese Patent Application Laid-Open Publication No. 2003-131463, Japanese Patent Application Laid-Open Publication No. 2004-107441, Japanese Patent Application Laid-Open Publication No. 2004-67658, Japanese Patent Application Laid-Open Publication No. 2003-342284, Japanese Patent Application Laid-Open Publication No. 2005-29784, Japanese Patent Application Laid-Open Publication No. 2005-29783, Japanese Patent Application Laid-Open Publication No. 2005-29782, Japanese Patent Application Laid-Open Publication No. 2005-23072, Japanese Patent Application Laid-Open Publication No. 2005-23071, Japanese Patent Application Laid-Open Publication No. 2005-23070, Japanese Patent Application Laid-Open Publication No. 2005-2101, Japanese Patent Application Laid-Open Publication No. 2005-2053, Japanese Patent Application Laid-Open Publication No. 2005-78996, Japanese Patent Application Laid-Open Publication No. 2005-68110, Japanese Patent Application Laid-Open Publication No. 2005-60374, Japanese Patent Application Laid-Open Publication No. 2005-44802, Japanese Patent Application Laid-Open Publication No. 2005-29785, Japanese Patent Application Laid-Open Publication No. 2005-104843, Japanese Patent Application Laid-Open Publication No. 2005-97549, Japanese Patent Application Laid-Open Publication No. 2005-220136, Japanese Patent Application Laid-Open Publication No. 2005-213348, Japanese Patent Application Laid-Open Publication No. 2005-170851, Japanese Patent Application Laid-Open Publication No. 2005-163036, Japanese Patent Application Laid-Open Publication No. 2005-154396, Japanese Patent Application Laid-Open Publication No. 2005-272411, Japanese Patent Application Laid-Open Publication No. 2005-327526, Japanese Patent Application Laid-Open Publication No. 2005-325048, Japanese Patent Application Laid-Open Publication No. 2005-314663, Japanese Patent Application Laid-Open Publication No. 2006-13222, Japanese Patent Application Laid-Open Publication No. 2006-8688, Japanese Patent Application Laid-Open Publication No. 2006-80419, Japanese Patent Application Laid-Open Publication No. 2006-76969, International Publication WO 2002/15645, International Publication WO 2002/02714, International Publication WO 2002/064700, International Publication WO 2003/033617, International Publication WO 2003/000661, International Publication WO 2002/081488 and US 2006/0251923 A1.

Examples of structural formulas of bidentate ligands forming a metal-nitrogen bond and a metal-carbon bond will be provided below. In the following structural formulas, R' is a hydrogen atom or a substituent, preferably a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group.
Specific examples and preferred examples of R' are similar to those of R¹ to R⁴.

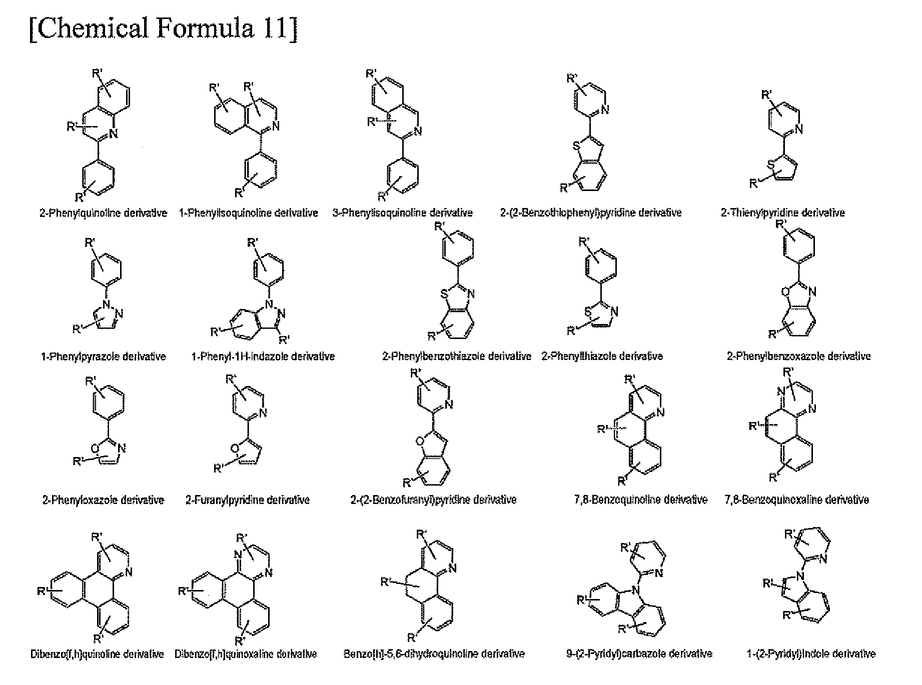

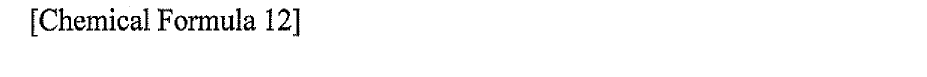

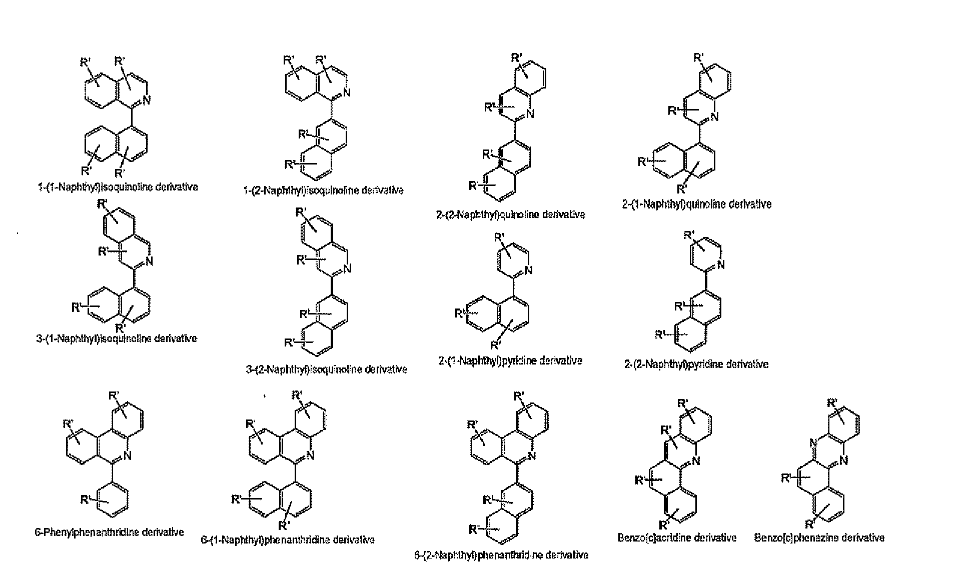

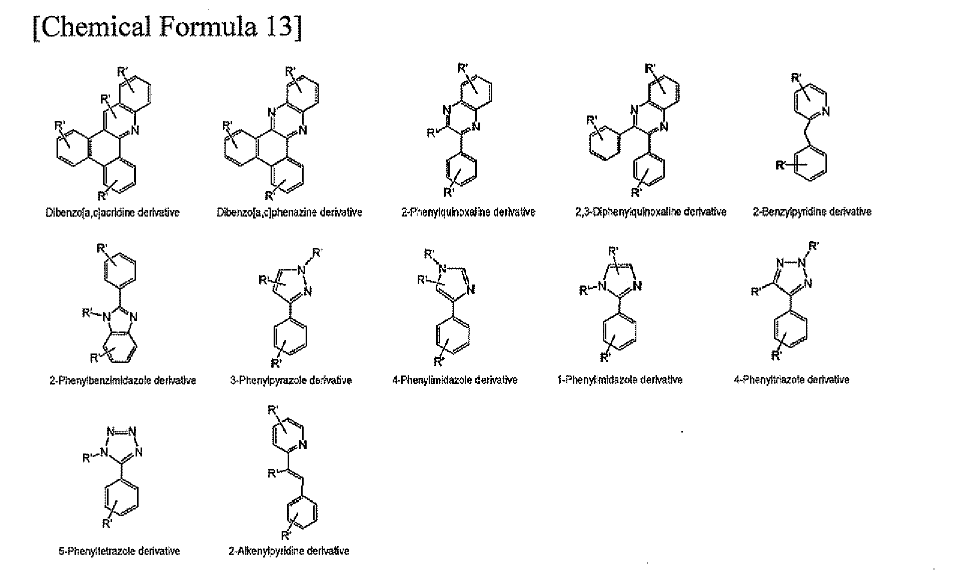

Examples of the bidentate ligand forming a metal-nitrogen bond and a metal-oxygen bond include a picolinic acid derivative, a pyridinesulfonic acid derivative, a quinolinesulfonic acid derivative and a quinolinecarboxylic acid derivative, with a picolinic acid derivative being preferred. These bidentate ligands are described in Japanese Patent Application Laid-Open Publication No. 2006-16394, Japanese Patent Application Laid-Open Publication No. 2006-307210, Japanese Patent Application Laid-Open Publication No. 2006-298900, International Publication WO 2006/028224, International Publication WO 2006/097717, Japanese Patent Application Laid-Open Publication No. 2004-111379 and Japanese Patent Application Laid-Open Publication No. 2005-29785.

Examples of the bidentate ligand forming two metal-oxygen bonds include a β-diketone derivative, a carboxylic acid derivative and a tropolone derivative, with a β-diketone derivative being preferred.
These bidentate ligands are described in Japanese Patent Application Laid-Open Publication No. 2005-35902, Japanese Patent Application Laid-Open Publication No. 2004-349224, Japanese Patent Application Laid-Open Publication No. 2006-28101 and Japanese Patent Application Laid-Open Publication No. 2005-29785.

Examples of the bidentate ligand forming two metal-nitrogen bonds include a 2,2'-bipyridine derivative, a 1,10-phenanthroline derivative, a 2,2'-biquinoline derivative, a 2,2'-dipyridylamine derivative, an imidazole derivative, a pyrazolyl borate derivative and a pyrazole derivative. These bidentate ligands are described in Japanese Patent Application Laid-Open Publication No. 2005-298483, Japanese Patent Application Laid-Open Publication No. 2006-213720 and Japanese Patent Application Laid-Open Publication No. 2003-133074.

Bidentate ligands particularly preferred as L are bidentate ligands represented by the following formulas (8) to (14). The bidentate ligands represented by the following formulas (8) to (11) are monoanionic bidentate ligands, and the bidentate ligands represented by the following formulas (12) to (14) are neutral bidentate ligands. 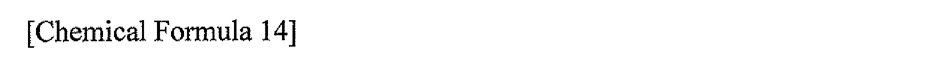 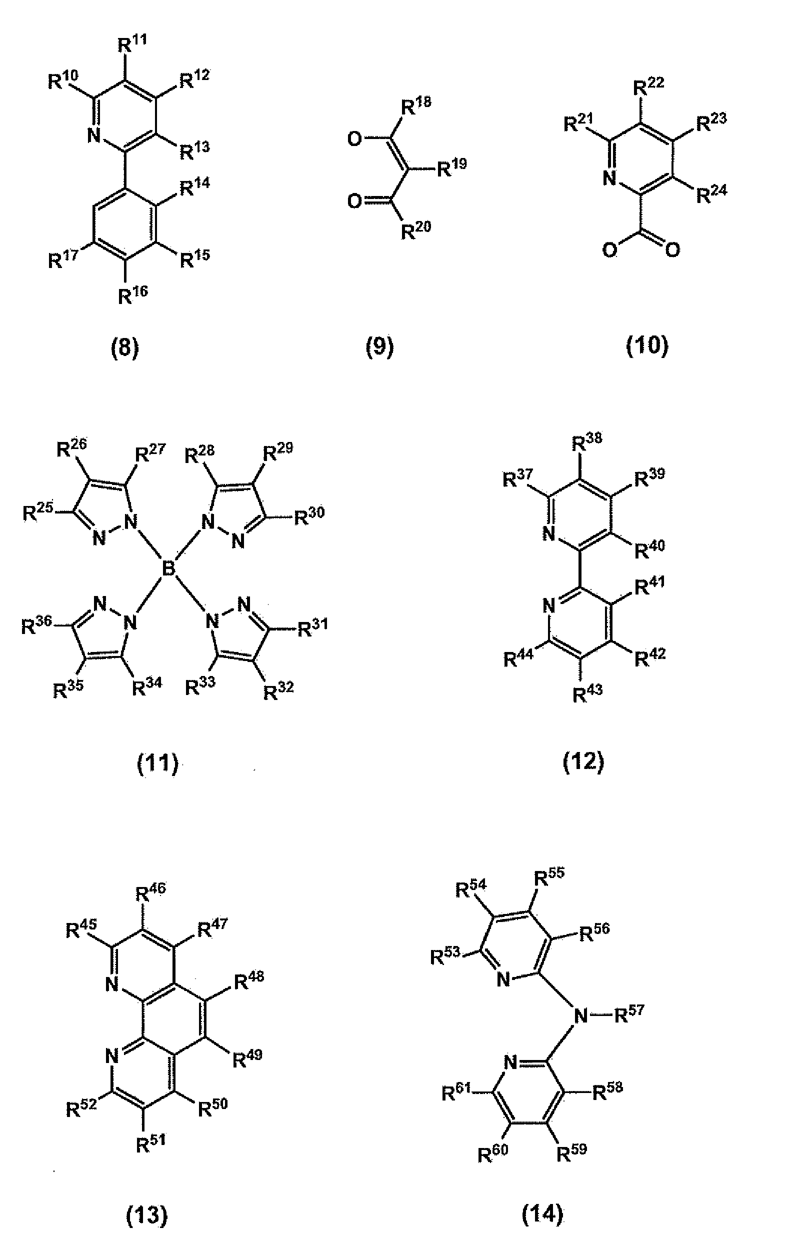 [In the formulas (8) to (14), R¹⁰ to R⁶¹ each independently represent a hydrogen atom, an alkyl group having 10 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a monovalent heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, provided that adjacent groups among R¹⁰ to R⁶¹ may be bonded to each other to form a ring structure.]

Specific examples of R¹⁰ to R⁶¹ are similar to those of R¹ to R⁴ in the formula (1), and preferred examples of R¹⁰ to R⁶¹ are as follows.

R¹⁰ to R¹⁷, R²¹ to R²⁴, R³⁷ to R⁵⁶ and R⁵⁸ to R⁶¹ are preferably a hydrogen atom, a halogen atom, a trifluoromethyl group, a cyano group, a carboxyl group, an alkyl group having 1 to 20 carbon atoms that may have a substituent, an aryl group having 6 to 30 carbon atoms that may have a substituent, or a heterocyclic group having 1 to 20 carbon atoms that may have a substituent, more preferably a hydrogen atom, an alkyl group having 1 to 10 carbon atoms that may have a substituent, or an aryl group having 6 to 12 carbon atoms that may have a substituent.

R¹⁸ and R²⁰ are preferably a trifluoromethyl group, an aryl group having 6 to 12 carbon atoms that may have a substituent, or an alkyl group having 1 to 10 carbon atoms that may have a substituent, more preferably an alkyl group having 1 to 5 carbon atoms that may have a substituent, still more preferably an alkyl group having 1 to 3 carbon atoms that may have a substituent.

R¹⁹ and R²⁵ to R³⁶ are preferably a hydrogen atom or an alkyl group having 1 to 10 carbon atoms that may have a substituent, more preferably a hydrogen atom or an alkyl group having 1 to 5 carbon atoms that may have a substituent, still more preferably a hydrogen atom.

R⁵⁷ is preferably a hydrogen atom, an alkyl group having 1 to 20 carbon atoms that may have a substituent, an aryl group having 6 to 30 carbon atoms that may have a substituent, or a heterocyclic group having 1 to 20 carbon atoms that may have a substituent, more preferably a hydrogen atom, an alkyl group having 1 to 10 carbon atoms that may have a substituent, or an aryl group having 6 to 12 carbon atoms that may have a substituent.

Further, it is preferred that adjacent groups among R¹⁰ to R¹⁷, R¹⁸ to R²⁰, R²¹ to R²⁴, R²⁵ to R³⁶, R³⁷ to R⁴⁴, R⁴⁵ to R⁵² and R⁵³ to R⁶¹ be bonded to each other to form a saturated or unsaturated carbocycle or a saturated or unsaturated heterocycle.

Referring back to the formula (7), the counterion represented by Q is preferably an alkali metal ion, an alkaline earth metal ion, a halide ion, a perchlorate ion, a PF₆ ion, an ammonium ion, a CF₃CF₂CF₂COO ion, an SbF₆ ion, a dicyanamide ion, a bis(trifluoromethanesulfonyl)amide ion, a borate ion, a phosphonium ion or a tetrakis[3,5-bis(trifluoromethyl)phenyl]borate ion.

In the formula (7), m represents an integer of 0 to 2 and m is preferably 0 or 1, more preferably 0.

The metal complex of the present invention can be produced by the following method, for example.
A phenylpyrimidine derivative that is a ligand precursor and iridium trichloride n-hydrate are mixed at a molar ratio of 2:1 to 3:1 in a solvent containing water and heated, thereby obtaining a binuclear iridium complex. The binuclear iridium complex is isolated as necessary, mixed with picolinic acid or acetylacetone and then reacted by heating, thereby obtaining a heteroleptic complex. On the other hand, the binuclear iridium complex is isolated as necessary, mixed with the phenylpyrimidine derivative and then reacted by heating, thereby obtaining a homoleptic complex. The phenylpyrimidine derivative can be produced by a known synthesis method.

Next, the charge transport material contained in the metal complex composition according to the present embodiment will be described.
The charge transport material (hereinafter, the "charge transport material" can be used as either of a hole transport material and an electron transport material) may be a low-molecular-weight organic compound or a polymer organic compound, and may be a combination of a low-molecular-weight organic compound and a polymer organic compound. The charge transport material may be either of a hole transport material and an electron transport material, and may be a combination of these materials.

Hole transport materials include aromatic amines, carbazole derivatives and polyparaphenylene derivatives.

Electron transport materials include metal complexes of oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, diphenoquinone derivatives, triazine and derivatives thereof and 8-hydroxyquinoline and derivatives thereof

Low-molecular-weight organic compounds as charge transport materials refer to charge transport materials having a molecular weight of less than 1000 and include host compounds and charge injection transport compounds used for low-molecular-weight organic EL devices. Specific examples may include compounds described in "Organic EL Displays" (co-authors: Shizuo Tokito, Chihaya Adachi, Hideyuki Murata, Ohmsha), p. 107, Monthly Display, vol. 9, No. 9, 2003, p. 26-30, Japanese Patent Application Laid-Open Publication No. 2004-24400 and Japanese Patent Application Laid-Open Publication No. 2004-277377.

Polymer compounds can also be preferably used as charge transport materials. Such polymer compounds include nonconjugated polymer compounds and conjugated polymer compounds.

The above nonconjugated polymer compound refers to a polymer compound that includes aromatic rings in the main chain and in which less than 80% of the aromatic rings contained in the main chain are bonded to each other by a direct bond, a conjugated bond group such as a vinylene group, or an atom having an unpaired electron such as an oxygen atom, a sulfur atom or a nitrogen atom.
The above conjugated polymer compound refers to a polymer compound that includes aromatic rings in the main chain and in which 80% or more of the aromatic rings contained in the main chain are bonded to each other by a direct bond, a conjugated bond group such as vinylene group, or an atom having an unpaired electron such as an oxygen atom, a sulfur atom or a nitrogen atom. In the above conjugated polymer compound, the above-described bonding form is preferably a direct bond or a nitrogen atom having an unpaired electron, more preferably a direct bond.

Examples of the above nonconjugated polymer compound include polyvinylcarbazole.

Examples of the above conjugated polymer compound include polymer compounds including a phenylenediyl group that may have a substituent, a fluorenediyl group that may have a substituent, a dibenzothiophenediyl group that may have a substituent, a dibenzofurandiyl group that may have a substituent, or a dibenzosilolediyl group that may have a substituent as a repeating unit in the main chain, and copolymers of those groups.

The above conjugated polymer compound preferably includes at least one constitutional unit selected from the group consisting of a constitutional unit represented by the following formula (2) and a constitutional unit represented by the following formula (3).
Preferred examples of the conjugated polymer compound include a copolymer of a constitutional unit represented by the following formula (2):

[Chemical Formula 15] -Ar¹- (2)

wherein in the formula (2), Ar¹ represents an arylene group, a divalent aromatic heterocyclic group, or a divalent group where two or more identical or different groups selected from the group consisting of the arylene groups and the divalent aromatic heterocyclic groups are directly bonded, provided that a group represented by Ar¹ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent; and a constitutional unit represented by the following formula (3): 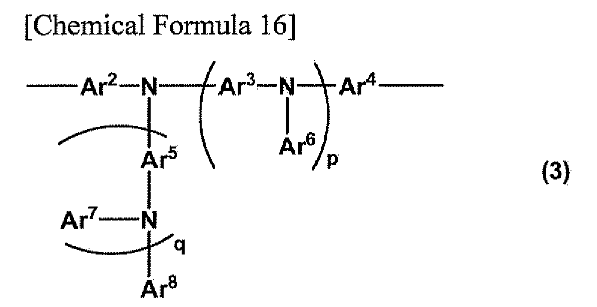 wherein in the formula (3), Ar², Ar³, Ar⁴ and Ar⁵ each independently represent an arylene group, a divalent aromatic heterocyclic group, or a divalent group where two or more identical or different groups selected from the group consisting of the arylene groups and the divalent aromatic heterocyclic groups are directly bonded, Ar⁶, Ar⁷ and Ar⁸ each independently represent an aryl group or a monovalent aromatic heterocyclic group, and p and q are each independently 0 or 1, provided that a group represented by Ar², Ar³, Ar⁴, Ar⁵, Ar⁶, Ar⁷ or Ar⁸ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, respectively, and a group represented by Ar⁵, Ar⁶, Ar⁷ or Ar⁸may be bonded directly or through -O-, -S-, -C(=O)-, -C(=O)-O-, -N(R^{A})-, -C(=O)-N(R^{A})- or -C(R^{A})₂- to a group represented by Ar², Ar³, Ar⁴, Ar⁵, Ar⁶, Ar⁷ or Ar⁸ bonded to a nitrogen atom with the group bonded thereto to form a five- to seven-membered ring, respectively, wherein R^{A} represents an alkyl group, an aryl group, a monovalent aromatic heterocyclic group or an aralkyl group.

The arylene group represented by Ar¹ in the above formula (2) is a residue in which two hydrogen atoms are removed from an aromatic hydrocarbon, and includes one having a fused ring. The arylene group has usually 6 to 60, preferably 6 to 48, more preferably 6 to 30, still more preferably 6 to 14, carbon atoms. This number of carbon atoms does not include the number of carbon atoms in the substituent(s).

Examples of the arylene group represented by Ar¹ include phenylene groups such as a 1,4-phenylene group (the following formula 2-001), a 1,3-phenylene group (the following formula 2-002) and a 1,2-phenylene group (the following formula 2-003); naphthalenediyl groups such as a naphthalene-1,4-diyl group (the following formula 2-004), a naphthalene-1,5-diyl group (the following formula 2-005) and a naphthalene-2,6-diyl group (the following formula 2-006); dihydrophenanthrenediyl groups such as a 4,5-dihydrophenanthrene-2,7-diyl group (the following formula 2-007); and fluorenediyl groups such as a fluorene-3,6-diyl group (the following formula 2-008) and a fluorene-2,7-diyl group (the following formula 2-009). Some or all of the hydrogen atoms composing these arylene groups may be replaced with an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group. 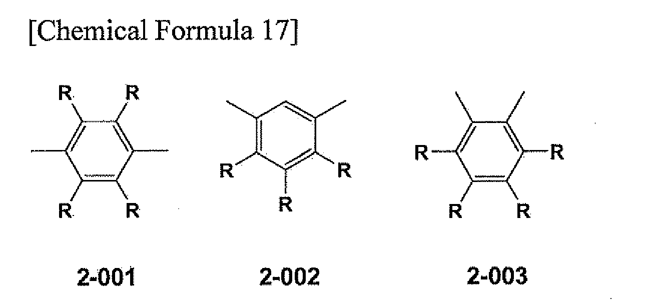 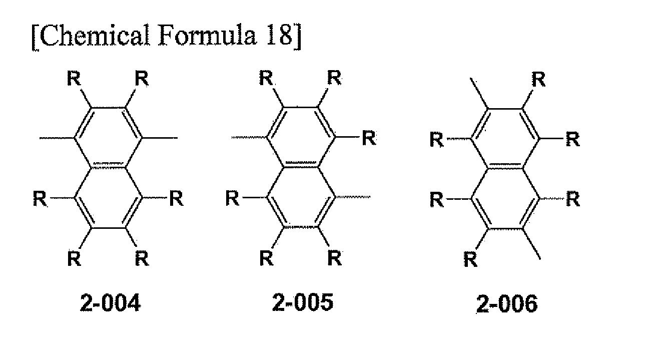 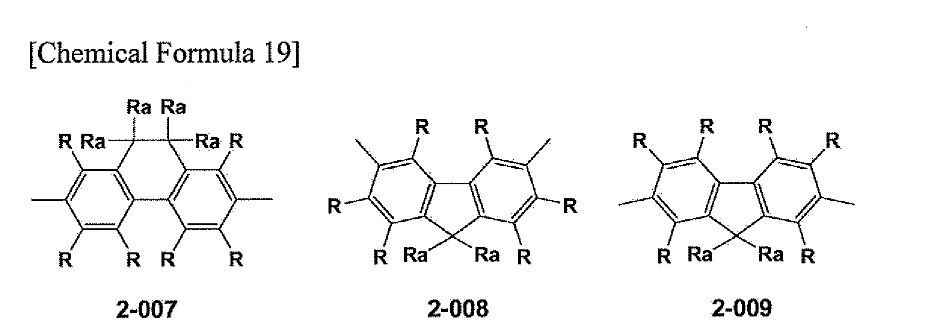 [In the formulas 2-001 to 2-009, R represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, and Ra represents an alkyl group, an aryl group, a monovalent aromatic heterocyclic group or an aralkyl group, provided that a plurality of Rs present may be identical or different, and a plurality of Ras present may be identical or different.]

In the above formulas 2-001 to 2-009, R is preferably a hydrogen atom, an alkyl group, an aryl group, a monovalent aromatic heterocyclic group, an alkoxy group, an aryloxy group, an aralkyl group or a substituted amino group, more preferably a hydrogen atom, an alkyl group or an aryl group.

In the above formulas 2-001 to 2-009, Ra is preferably an aryl group or an alkyl group, more preferably an alkyl group, an unsubstituted aryl group, or an aryl group substituted with an alkyl group, an alkoxy group or an aryl group.

The divalent aromatic heterocyclic group represented by Ar¹ in the above formula (2) is a residue in which two hydrogen atoms are removed from an aromatic heterocyclic compound, and also includes one having a fused ring. The divalent aromatic heterocyclic group has usually 3 to 60, preferably 3 to 20, carbon atoms. This number of carbon atoms does not include the number of carbon atoms in the substituent(s).

Examples of the divalent aromatic heterocyclic group represented by Ar¹ include pyridinediyl groups such as a pyridine-2,5-diyl group (the following formula 2-101) and a pyridine-2,6-diyl group (the following formula 2-102); pyrimidinediyl groups such as a pyrimidine-4,6-diyl group (the following formula 2-103); a triazine-2,4-diyl group (the following formula 2-104); pyrazinediyl groups such as a pyrazine-2,5-diyl group (the following formula 2-105); pyridazinediyl groups such as a pyridazine-3,6-diyl group (the following formula 2-106); quinolinediyl groups such as a quinoline-2,6-diyl group (the following formula 2-107); isoquinolinediyl groups such as an isoquinoline-1,4-diyl group (the following formula 2-108); quinoxalinediyl groups such as a quinoxaline-5,8-diyl group (the following formula 2-109); carbazolediyl groups such as a carbazole-3,6-diyl group (the following formula 2-110) and a carbazole-2,7-diyl group (the following formula 2-111); dibenzofurandiyl groups such as a dibenzofuran-4,7-diyl group (the following formula 2-112) and a dibenzofuran-3,8-diyl group (the following formula 2-113); dibenzothiophenediyl groups such as a dibenzothiophene-4,7-diyl group (the following formula 2-114) and a dibenzothiophene-3,8-diyl group (the following formula 2-115); dibenzosilolediyl groups such as a dibenzosilole-4,7-diyl group (the following formula 2-116) and a dibenzosilole-3,8-diyl group (the following formula 2-117); phenoxazinediyl groups such as a phenoxazine-3,7-diyl group (the following formula 2-118) and a phenoxazine-2,8-diyl group (the following formula 2-119); phenothiazinediyl groups such as a phenothiazine-3,7-diyl group (the following formula 2-120) and a phenothiazine-2,8-diyl group (the following formula 2-121); dihydroacridinediyl groups such as a dihydroacridine-2,7-diyl group (the following formula 2-123); a divalent group represented by the following formula 2-124; pyrrolediyl groups such as a pyrrole-2,5-diyl group (the following formula 2-125); furandiyl groups such as a furan-2,5-diyl group (the following formula 2-126); thiophenediyl groups such as a thiophene-2,5-diyl group (the following formula 2-127); diazolediyl groups such as a diazole-2,5-diyl group (the following formula 2-128); triazolediyl groups such as a triazole-2,5-diyl group (the following formula 2-129); oxazolediyl groups such as an oxazole-2,5-diyl group (the following formula 2-130); an oxadiazole-2,5-diyl group (the following formula 2-131); thiazolediyl groups such as a thiazole-2,5-diyl group (the following formula 2-132); and a thiadiazole-2,5-diyl group (the following formula 2-133). These divalent aromatic heterocyclic groups may be substituted with an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group. 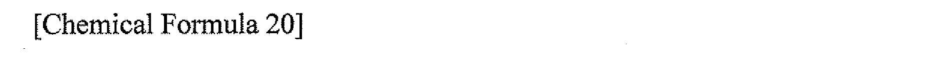 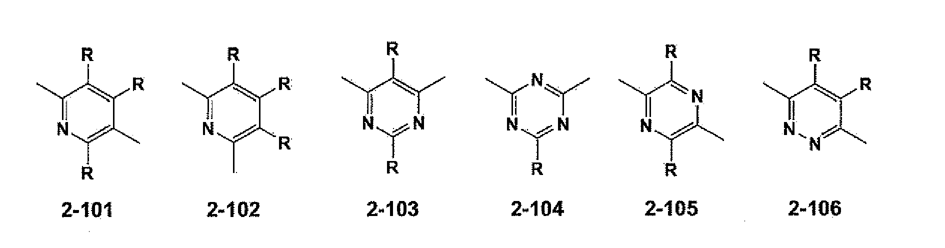 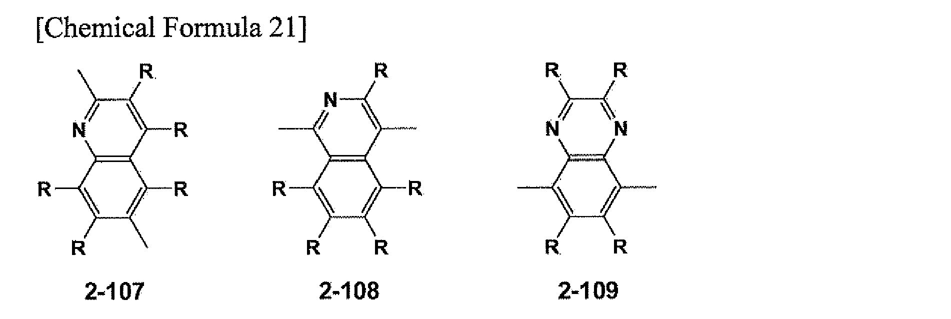 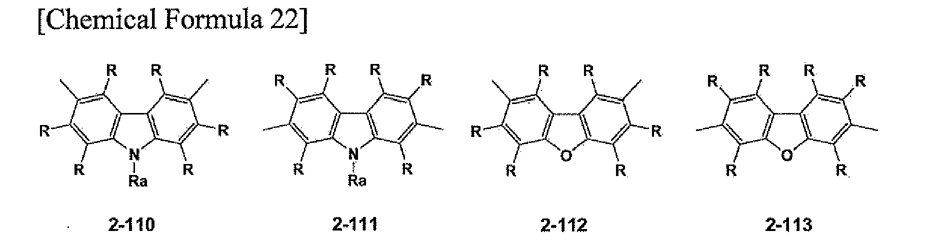 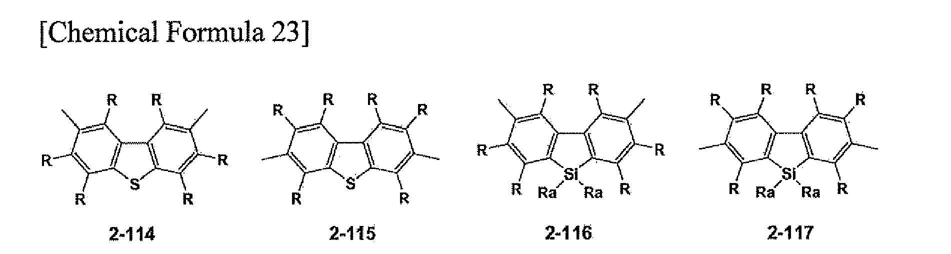 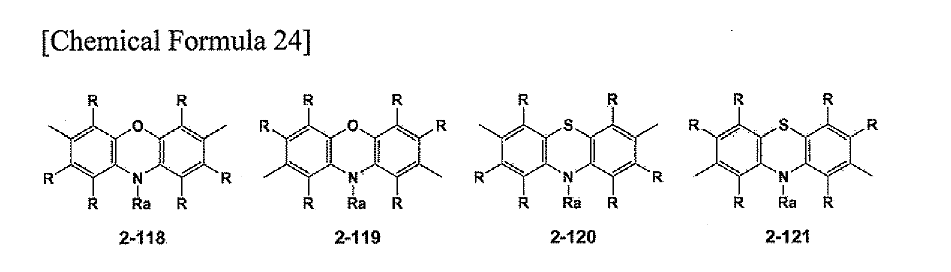 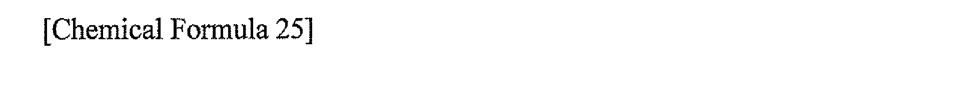 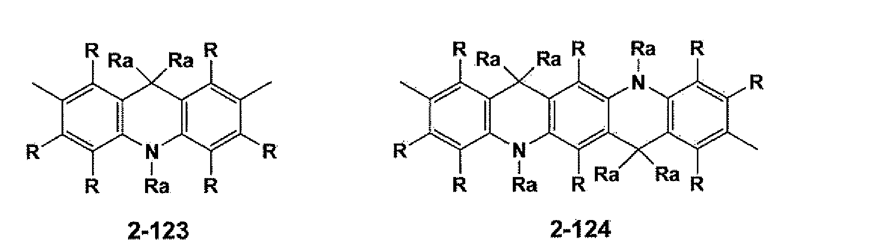 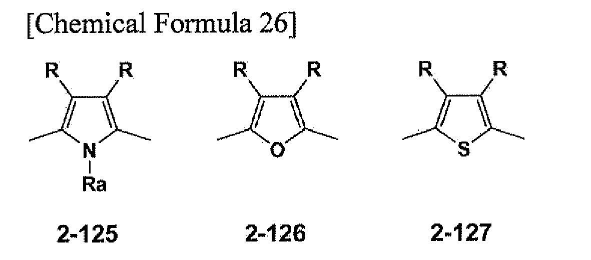 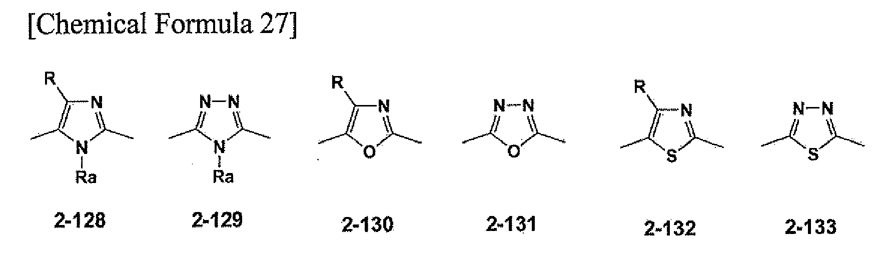 [The definitions and illustrations of R and Ra in the formulas 2-101 to 2-133 are the same as those of R and Ra in the formulas 2-001 to 2-009, respectively.]

Examples of the divalent group represented by Ar¹ in the above formula (2), where two or more identical or different groups selected from the group consisting of the arylene groups and the divalent aromatic heterocyclic groups are directly bonded, include groups represented by the following formulas 2-201 to 2-219. 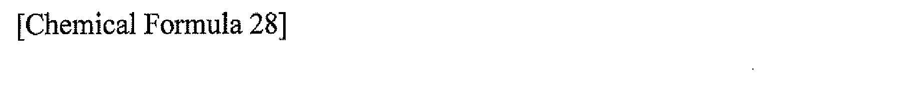 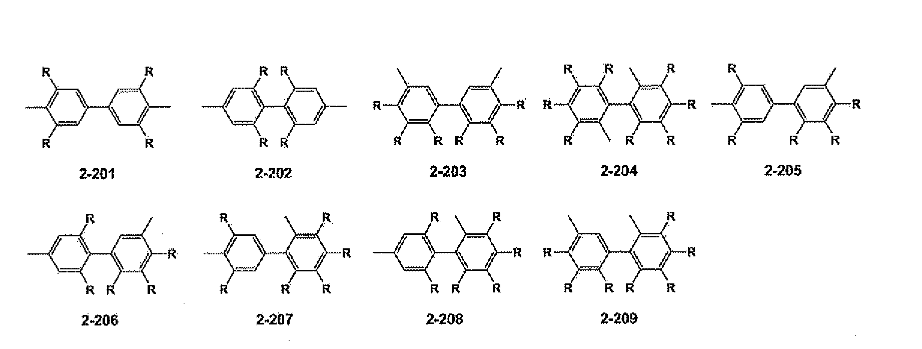 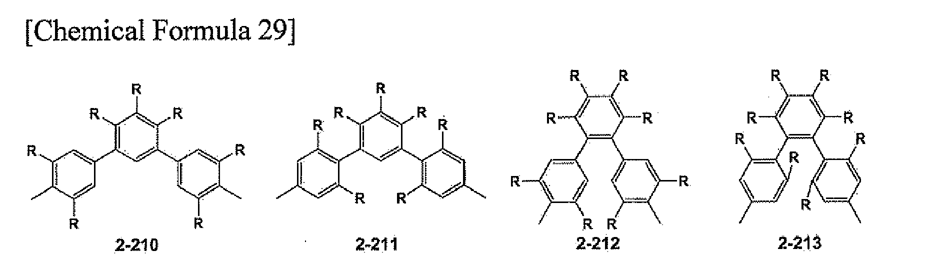 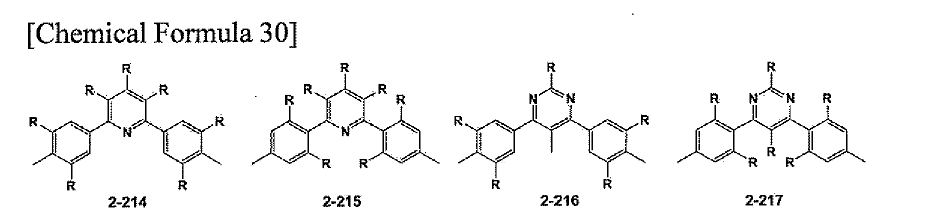 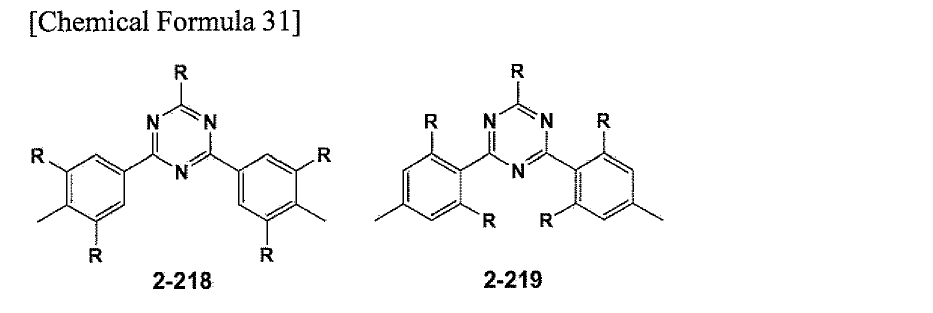 [The definition and illustration of R in the formulas 2-201 to 2-219 are the same as those ofR in the formulas 2-001 to 2-009.]

The constitutional unit represented by the above formula (2) is preferably a constitutional unit consisting of a group represented by the above formula 2-001, a group represented by the above formula 2-009, a group represented by the above formula 2-218 or a group represented by the above formula 2-219.

The conjugated polymer compound according to the present embodiment preferably includes a constitutional unit represented by the following formula (4) as the constitutional unit represented by the above formula (2) in terms of luminous efficiency of the resulting organic electroluminescence device, and preferably includes a constitutional unit represented by the following formula (5) as the constitutional unit represented by the above formula (2) in terms of drive voltage of the resulting organic electroluminescence device. 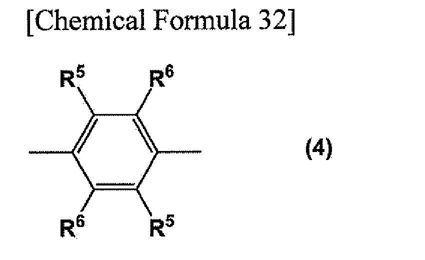 [In the formula (4), R⁵ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group or a cyano group, and R⁶ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that two R⁵s may be identical or different, and two R⁶S may be identical or different.] 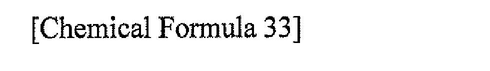 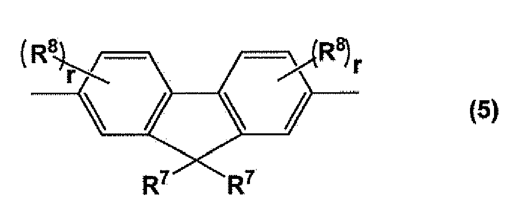 [In the formula (5), R⁷ represents an alkyl group, an aryl group, a monovalent aromatic heterocyclic group or an aralkyl group, R⁸ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, and r represents an integer of 0 to 3, provided that two R⁷s may be identical or different, and two R⁷s may be bonded to form a ring structure, that when a plurality of R⁸s are present, the plurality of R⁸s may be identical or different, and that two rs may be identical or different.]

The group represented by R⁵ in the above formula (4) is preferably an alkyl group, an aryl group, a monovalent aromatic heterocyclic group, an alkoxy group, an aryloxy group, an aralkyl group or a substituted amino group, more preferably an alkyl group or an aralkyl group, still more preferably an alkyl group, particularly preferably a propyl group, an isopropyl group, a butyl group, an s-butyl group, an isobutyl group, a pentyl group, an isoamyl group, a hexyl group, a cyclohexyl group, a heptyl group, an octyl group, a 2-ethylhexyl group, a cyclohexylmethyl group, a nonyl group, a decyl group, a 3,7-dimethyloctyl group or a dodecyl group in terms of the balance between heat resistance and solubility in an organic solvent of the charge transport material.

The group represented by R⁶ in the above formula (4) is preferably a hydrogen atom, an alkyl group, an alkoxy group, an aryl group, a monovalent aromatic heterocyclic group or an aralkyl group, more preferably a hydrogen atom or an alkyl group, particularly preferably a hydrogen atom in terms of heat resistance, solubility in an organic solvent and reactivity during polymerization of the charge transport material.

Examples of the constitutional unit represented by the above formula (4) include constitutional units represented by the following formulas 4-001 to 4-017 and 4-101 to 4-105.

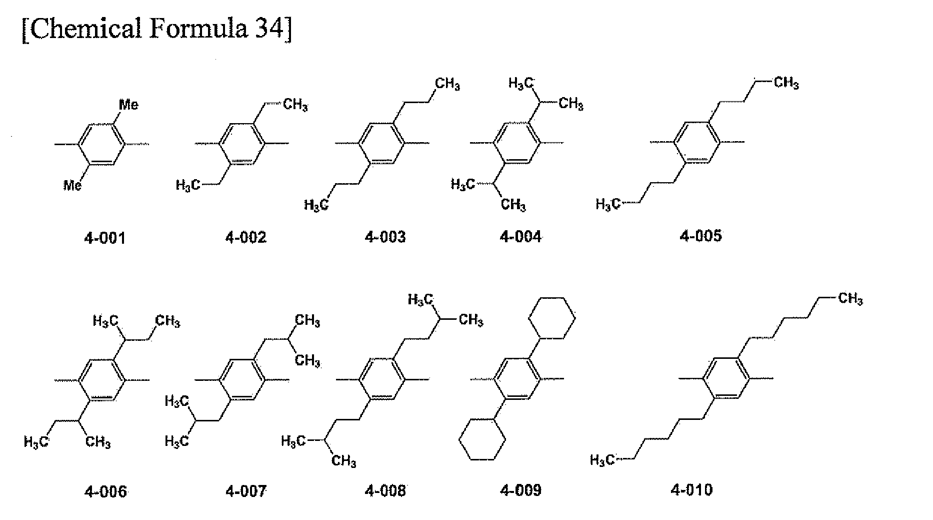

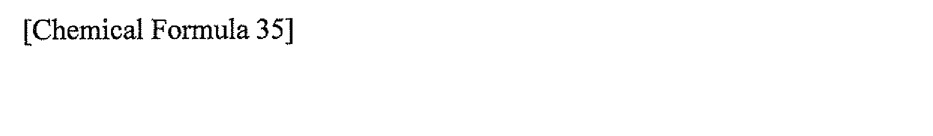

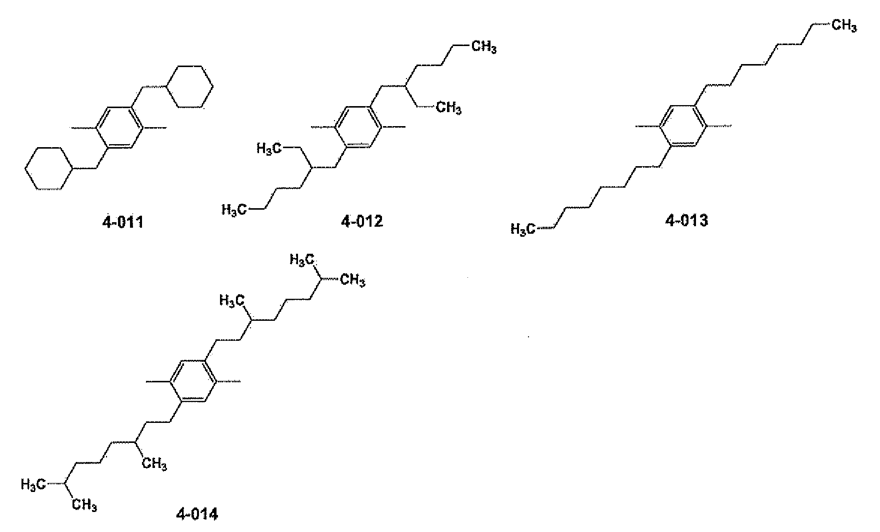

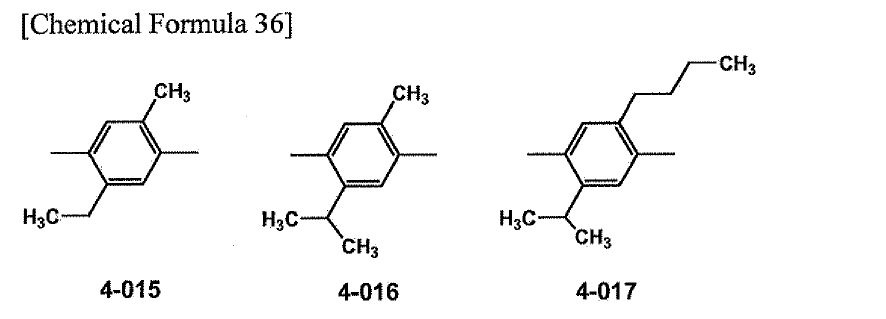

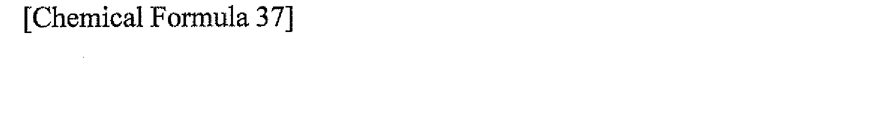

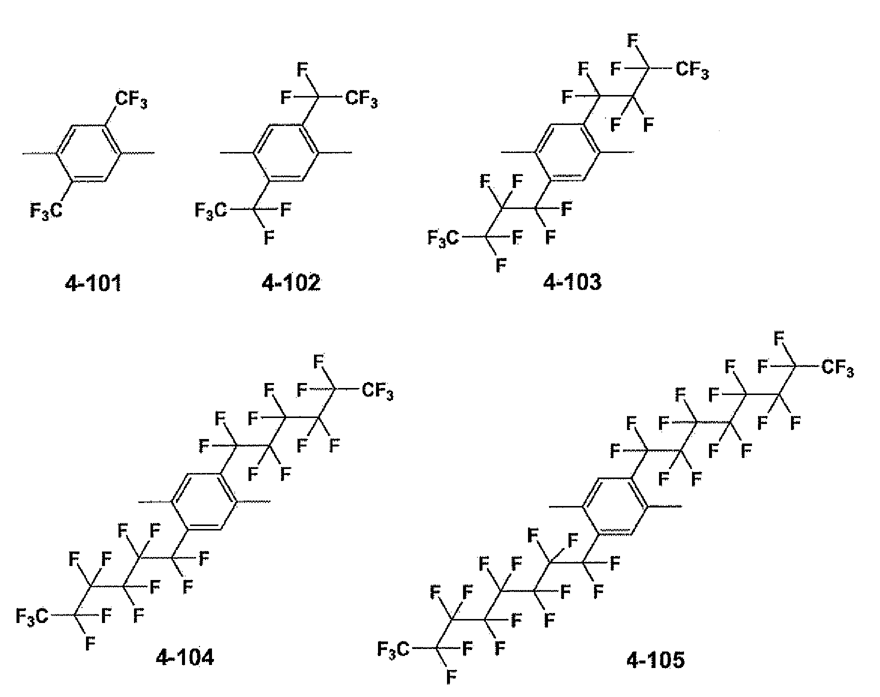

The group represented by R⁷ in the above formula (5) is preferably an aryl group or an alkyl group, more preferably an unsubstituted aryl group, or an aryl group substituted with an alkyl group, an alkoxy group, an aryl group or a substituted amino group, or an alkyl group, particularly preferably a 4-tolyl group, a 4-butylphenyl group, a 4-t-butylphenyl group, a 4-hexylphenyl group, a 4-octylphenyl group, a 4-(2-ethylhexyl)phenyl group, a 4-(3,7-dimethyloctyl)phenyl group, a 3-tolyl group, a 3-butylphenyl group, a 3-t-butylphenyl group, a 3-hexylphenyl group, a 3-octylphenyl group, a 3-(2-ethylhexyl)phenyl group, a 3-(3,7-dimethyloctyl)phenyl group, a 3,5-dimethylphenyl group, a 3,5-di-(t-butyl)phenyl group, a 3,5-dihexylphenyl group, a 3,5-dioctylphenyl group, a 3,4-dihexylphenyl group, a 3,4-dioctylphenyl group, a 4-hexyloxyphenyl group, a 4-octyloxyphenyl group, a 4-(2'-ethoxyethyloxy)phenyl group, a 4-(4'-t-butylbiphenyl) group, a 9,9-dihexylfluoren-2-yl group or a 9,9-dioctylfluoren-2-yl group in terms of the balance between heat resistance and solubility in an organic solvent of the polymer compound.

The group represented by R⁸ in the above formula (5) is preferably an alkyl group, an alkoxy group or an aryl group.

In the above formula (5), r represents an integer of 0 to 3, and is preferably 0 or 1. In particular, it is preferred that one of the two rs present be 0 with the other being 1, or both of the two rs present be 0, and it is especially preferred that both of the two rs present be 0.

When the charge transport material according to the present embodiment is a conjugated polymer compound including a constitutional unit represented by the above formula (2), only one constitutional unit represented by the above formula (2) or two or more such constitutional units may be contained in the conjugated polymer compound. For example, only any one constitutional unit represented by the above formula (4) or (5) may be contained or both a constitutional unit represented by the above formula (4) and a constitutional unit represented by the above formula (5) may be contained as the constitutional unit(s) represented by the above formula (2). Further, two or more constitutional units represented by the above formula (4) and/or two or more constitutional units represented by the above formula (5) may be contained.

Next, the constitutional unit represented by the above formula (3) will be described in detail. Examples of the constitutional unit represented by the above formula (3) include constitutional units represented by the following formulas 3-001 to 3-004. 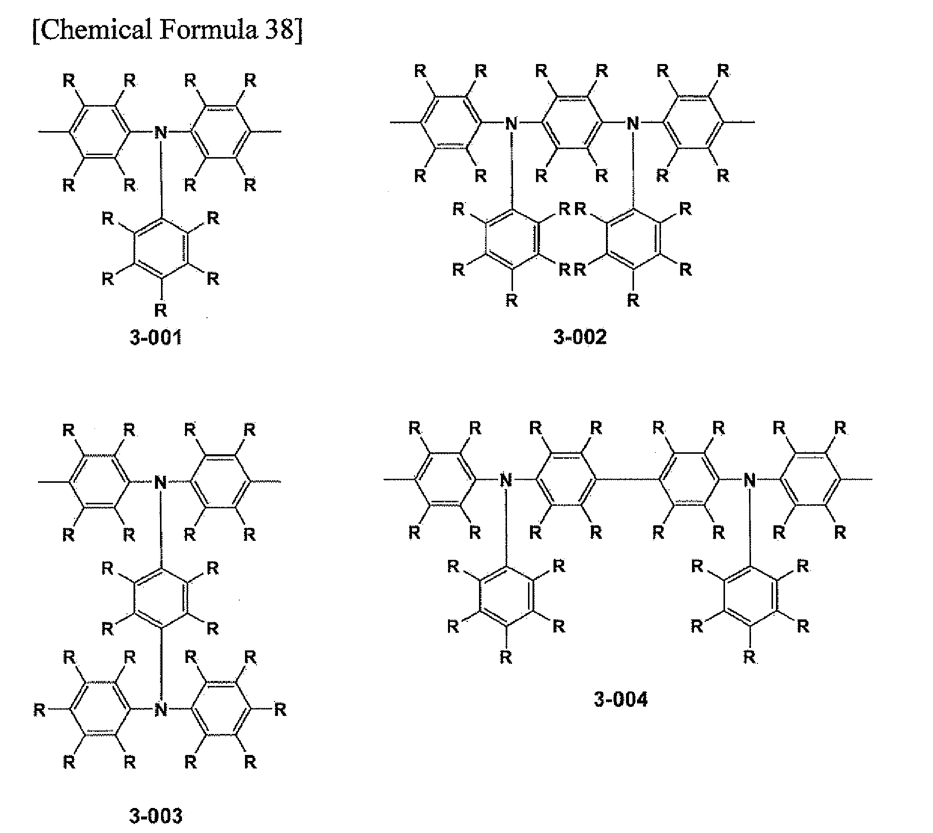 [The definition and illustration of R in the formulas 3-001 to 3-004 are the same as those of R in the formulas 2-001 to 2-009.]

When the charge transport material according to the present embodiment is a conjugated polymer compound including a constitutional unit represented by the above formula (3), only one constitutional unit represented by the above formula (3) or two or more such constitutional units may be contained in the conjugated polymer compound. Further, both a constitutional unit represented by the above formula (2) and a constitutional unit represented by the above formula (3) may be contained in the conjugated polymer compound.

When the charge transport material according to the present embodiment is a polymer compound, the polystyrene-equivalent number average molecular weight of the polymer compound is 10³ to 10⁸, preferably 10⁴ to 10⁶. The polystyrene- equivalent weight average molecular weight is 10³ to 10⁸, preferably 5 × 10⁴ to 5 × 10⁶. If the number average molecular weight of the polymer compound is 5 × 10⁴ to 5 × 10⁶, processability of an organic film including the polymer compound is satisfactory, and mechanical strength of the organic film is also satisfactory.

In the metal complex composition according to the present embodiment, the metal complex including a structure represented by the above formula (1) and the above charge transport material may be provided as either one type or two or more types, respectively. For example, when the metal complex composition according to the present embodiment comprises, as the charge transport material, a polymer compound including at least one constitutional unit selected from the group consisting of a constitutional unit represented by the above formula (2) and a constitutional unit represented by the above formula (3), the composition preferably further comprises, in terms of electron injection and electron transport, an electron transport material (charge transport material (C)) having a structure represented by the following formula (6): 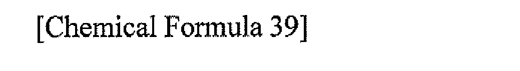 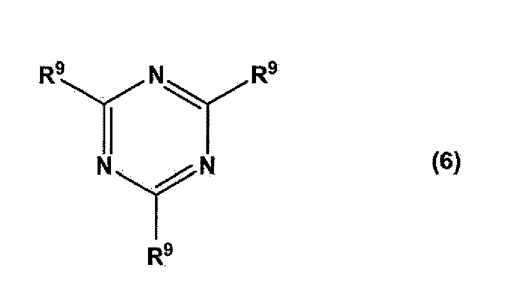 wherein in the formula (6), R⁹ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that three R⁹s may be identical or different.

The metal complex composition according to the present embodiment may consist only of the metal complex including a structure represented by the above formula (1) and the charge transport material, or may further comprise a component other than the metal complex having a structure represented by the above formula (1) and the charge transport material. Examples of the component other than the above metal complex and charge transport material include luminescent materials other than the metal complex having a structure represented by the above formula (1). As such luminescent materials, known compounds can be used, specifically, metal complexes of naphthalene derivatives, anthracene and derivatives thereof, perylene and derivatives thereof, dyes such as polymethine, xanthene, coumarin and cyanine dyes, and 8-hydroxyquinoline and derivatives thereof; low-molecular-weight compounds such as aromatic amines, tetraphenylcyclopentadiene and derivatives thereof, and tetraphenylbutadiene and derivatives thereof; and the like can be used.

In the metal complex composition according to the present embodiment, the content of each of the metal complex including a structure represented by the above formula (1) and the charge transport material can be adjusted according to the types of the metal complex and the charge transport material combined and the intended characteristics. In the above metal complex composition, the content of the metal complex including a structure represented by the above formula (1) is usually 0.01 to 80 parts by weight, preferably 0.1 to 60 parts by weight, based on 100 parts by weight of the above charge transport compound.

### [Second embodiment; Complex polymer]

The complex polymer according to the second embodiment of the present invention comprises a divalent group that is a residue where two hydrogen atoms are removed from a metal complex including a structure represented by the above formula (1) and at least one constitutional unit selected from the group consisting of a constitutional unit represented by the above formula (2) and a constitutional unit represented by the above formula (3). The metal complex including a structure represented by the above formula (1) which provides the divalent group, and at least one constitutional unit selected from the group consisting of a constitutional unit represented by the above formula (2) and a constitutional unit represented by the above formula (3) are similar to those in the above first embodiment, respectively, and a repeated description is omitted here.

Having the above configuration, the complex polymer according to the present embodiment has an effect similar to that of the metal complex composition according to the above first embodiment in which luminous efficiency of an organic electroluminescence device can be sufficiently improved. Further, the complex polymer is also preferred in terms of workability in the manufacture of an organic electroluminescence device.

### [Third embodiment; Liquid composition]

The liquid composition according to the third embodiment of the present invention comprises the metal complex composition according to the above first embodiment or the complex polymer according to the above second embodiment and a solvent. In the present specification, the "liquid composition" refers to one that is liquid during device fabrication, and typically refers to one that is liquid at normal pressure (i.e., 1 atm) and 25°C. Liquid compositions may generally be called inks, ink compositions, solutions or the like.

The solvent contained in the liquid composition is preferably one that can dissolve or disperse a component other than the solvent in the liquid composition. Examples of the solvent include chlorine solvents such as chloroform, methylene chloride, 1,2-dichloroethane, 1,1,2-trichloroethane, chlorobenzene and o-dichloxobenzene, ether solvents such as tetrahydrofuran and dioxane, aromatic hydrocarbon solvents such as toluene, xylene, trimethylbenzene and mesitylene, aliphatic hydrocarbon solvents such as cyclohexane, methylcyclohexane, n-pentane, n-hexane, n-heptane, n-octane, n-nonane and n-decane, ketone solvents such as acetone, methyl ethyl ketone and cyclohexanone, ester solvents such as ethyl acetate, butyl acetate, methyl benzoate and ethyl cellosolve acetate, polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerol and 1,2-hexanediol, alcohol solvents such as methanol, ethanol, propanol, isopropanol and cyclohexanol, sulfoxide solvents such as dimethyl sulfoxide, and amide solvents such as N-methyl-2-pyrolidone and N,N-dimethylformamide. These solvents may be used singly or in a combination of two or more. The liquid composition preferably comprises one or more organic solvents having a structure including at least one benzene ring and having a melting point of 0°C or lower and a boiling point of 100°C or higher among the above solvents in terms of viscosity, deposition properties and the like.

Among the above solvents, aromatic hydrocarbon solvents, aliphatic hydrocarbon solvents, ester solvents and ketone solvents are preferred, toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenyl cyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone and dicyclohexyl ketone are more preferred, and xylene, anisole, mesitylene, cyclohexylbenzene, bicyclohexyl and methyl benzoate are still more preferred in terms of solubility in an organic solvent, uniformity during deposition, viscosity characteristics, and the like of the component other than the solvent in the liquid composition. "i-" represents iso-.

The liquid composition may comprise one solvent or two or more solvents.
When the liquid composition comprises two solvents, preferred examples of combinations of the solvents in terms of viscosity and deposition properties include a combination of anisole and bicyclohexyl, a combination of anisole and cyclohexylbenzene, a combination of xylene and bicyclohexyl, a combination of xylene and cyclohexylbenzene, and a combination of mesitylene and methyl benzoate.

When the liquid composition comprises two solvents, either of the solvents may be in a solid state at 25°C. It is preferred to combine a solvent having a boiling point of 180°C or higher with a boiling point of lower than 180°C, and is more preferred to combine a solvent having a boiling point of 200°C or higher with a boiling point of lower than 180°C in terms of deposition properties. The solid content in the liquid composition is preferably dissolved in the above solvents at a concentration of 0.2 wt% or more at 60°C, and the solid content in the liquid composition is preferably dissolved in one of the two solvents at a concentration of 0.2 wt% or more at 25°C in terms of viscosity.

When the liquid composition comprises three solvents, one or two of the solvents may have a melting point of 25°C or higher. It is preferred that at least one of the three solvents be a solvent having a boiling point of 180°C or higher and at least one be a solvent having a boiling point of lower than 180°C, and it is more preferred that at least one of the three solvents be a solvent having a boiling point of 200°C to 300°C and at least one be a solvent having a boiling point of lower than 180°C in terms of deposition properties. The solid content in the liquid composition is preferably dissolved in two of the three solvents at a concentration of 0.2 wt% or more at 60°C, and the solid content in the liquid composition is preferably dissolved in one of the three solvents at a concentration of 0.2 wt% or more at 25°C in terms of viscosity.

The percentage of the solvent(s) in the liquid composition is usually 1 to 99.9 wt%, preferably 60 to 99.9 wt%, still more preferably 90 to 99.8 wt% based on the total weight of the liquid composition. Although the viscosity of the liquid composition varies depending on the printing method, the viscosity preferably ranges from 0.5 to 500 mPa·s at 25°C, and the viscosity preferably ranges from 0.5 to 20 mPa·s at 25°C in terms of prevention of clogging and curved flight during discharge in a printing method such as inkjet printing in which the liquid composition is discharged through a discharge device. The sum of the weights of the metal complex and the charge transport material according to the above first embodiment, or the weight of the complex polymer according to the above second embodiment is usually 20 to 100 wt%, preferably 40 to 100 wt%, based on the total weight of the solid content in the liquid composition.

When the liquid composition comprises two or more solvents, the percentage of the solvent having the highest boiling point is preferably 40 to 90 wt%, more preferably 50 to 90 wt%, still more preferably 65 to 85%, based on the total weight of the solvents contained in the liquid composition in terms of viscosity and deposition properties.

The difference between the solubility parameter of the solvent and the solubility parameter of the polymer contained in the composition of the present invention or the polymer compound of the present invention is preferably 10 or less, more preferably 7 or less, in terms of solubility in a solvent of the component other than the solvent contained in the liquid composition. These solubility parameters can be determined by the method described in "Solvent Handbook (published by Kodansha, 1976)".

The liquid composition according to the present embodiment is useful in the manufacture of an organic electroluminescence device such as a polymer light-emitting device. For example, in the fabrication of an organic electroluminescence device, deposition using the liquid composition can be performed only by applying the liquid composition and then removing the solvent by drying. The drying may be performed in a warmed condition at 50 to 150°C or under reduced pressure at about 10⁻³ Pa.

Application methods such as spin coating, casting, microgravure coating, gravure coating, bar coating, roll coating, wire bar coating, dip coating, spray coating, screen printing, flexographic printing, offset printing and inkjet printing can be used as deposition methods using the liquid composition.

### [Fourth embodiment; Organic film, organic electroluminescence device, planar light source and display]

The organic film according to the fourth embodiment of the present invention comprises the metal complex composition according to the above first embodiment or the complex polymer according to the above second embodiment. The organic film is useful as a functional layer of an organic electroluminescence device, and in particular, an organic electroluminescence device having sufficiently high luminous efficiency can be realized by composing a luminescent layer using the organic film. An organic electroluminescence device comprising a luminescent layer made of the organic film will be described in detail below.

Examples of the layer structure of the organic electroluminescence device according to the present embodiment include the following structures a) to d).
a) anode/luminescent layer/cathode
b) anode/hole transport layer/luminescent layer/cathode
c) anode/luminescent layer/electron transport layer/cathode
d) anode/hole transport layer/luminescent layer/electron transport layer/cathode
(Here, the symbol "/" indicates that each layer is adjacently laminated; hereinafter the same.)

Among hole transport layers and electron transport layers provided adjacent to electrodes, those having a function of improving efficiency of injecting charges (holes, electrons) from electrodes and having an effect of reducing drive voltage of the device may be called charge injection layers (hole injection layers, electron injection layers).

Further, the above charge injection layer or an insulating layer may be provided adjacent to an electrode in order to enhance adhesion to the electrode or improve charge injection from the electrode. A thin buffer layer may also be inserted into the interface of the above charge transport layer or luminescent layer in order to enhance adhesion of the interface and prevent mixing, for example. The order or number of the layers laminated and the thickness of each layer may be adjusted taking luminous efficiency and device life into consideration.

Examples of the layer structure of the organic electroluminescence device comprising a charge injection layer include the following structures e) to p).
e) anode/charge injection layer/luminescent layer/cathode
f) anode/luminescent layer/charge injection layer/cathode
g) anode/charge injection layer/luminescent layer/charge injection layer/cathode
h) anode/charge injection layer/hole transport layer/luminescent layer/cathode
i) anode/hole transport layer/luminescent layer/charge injection layer/cathode
j) anode/charge injection layer/hole transport layer/luminescent layer/charge injection layer/cathode
k) anode/charge injection layer/luminescent layer/charge transport layer/cathode
l) anode/luminescent layer/electron transport layer/charge injection layer/cathode
m) anode/charge injection layer/luminescent layer/electron transport layer/charge injection layer/cathode
n) anode/charge injection layer/hole transport layer/luminescent layer/charge transport layer/cathode
o) anode/hole transport layer/luminescent layer/electron transport layer/charge injection layer/cathode
p) anode/charge injection layer/hole transport layer/luminescent layer/electron transport layer/charge injection layer/cathode

The anode is usually transparent or semitransparent and is composed of a thin film of a metal oxide, metal sulfide or metal having a high electric conductivity and preferably composed of such a material having a high transmittance. Films (such as NESA) fabricated using conductive inorganic compounds made of indium oxide, zinc oxide, tin oxide and their composites such as indium tin oxide (ITO) and indium zinc oxide; and gold, platinum, silver, copper, and the like are used as materials of the anode, with ITO, indium zinc oxide and tin oxide being preferred. Methods such as vacuum evaporation, sputtering, ion plating and plating can be used for fabricating the anode. Organic transparent conductive films of polyaniline and derivatives thereof, polythiophene and derivatives thereof, and the like may also be used as such anodes.

The thickness of the anode may be selected taking light transmittance and electric conductivity into consideration and is usually 10 nm to 10 µm, preferably 20 nm to 1 µm, more preferably 50 nm to 500 nm.

Materials used for the hole injection layer include phenylamines, starburst-type amines, phthalocyanines, oxides such as vanadium oxide, molybdenum oxide, ruthenium oxide and aluminum oxide, amorphous carbon, and conductive polymer compounds such as polyaniline and derivatives thereof and polythiophene and derivatives thereof.

When the material used for the hole injection layer is a conductive polymer compound, the conductive polymer compound may be doped with an anion such as a polystyrenesulfonate ion, an alkylbenzenesulfonate ion or a camphorsulfonate ion to improve its electric conductivity.

Materials used for the hole transport layer include hole transport materials illustrated in the description of the above first embodiment. When the material used for the hole transport layer is a low-molecular-weight compound, the material is preferably used as a dispersion in a polymer binder. As the polymer binder, a compound that does not extremely inhibit charge transport is preferred, and a compound that does not strongly absorb visible light is suitably used. Examples of the polymer binder include polycarbonate, polyacrylate, polymethyl acrylate, polymethyl methacrylate, polystyrene, polyvinyl chloride and polysiloxane.

When the hole transport material is a polymer compound, the polymer compound preferably includes a hole transport group (such as an aromatic amino group or a thienyl group) as a constitutional unit and/or a substituent of the polymer compound.

Preferred examples of the hole transport material used for the hole transport layer include polyvinylcarbazole and derivatives thereof, polysilane and derivatives thereof, polysiloxane derivatives having an aromatic amine on the side chain or main chain, polyarylamine and derivatives thereof, and polymer compounds illustrated in the description of the above first embodiment and including at least one constitutional unit selected from the group consisting of a constitutional unit represented by the formula (2) and a constitutional unit represented by the formula (3).

Examples of the method of forming the hole transport layer when the hole transport material is a low-molecular-weight compound include deposition from a mixed solution containing the low-molecular-weight compound and a polymer binder. Examples of the method when the hole transport material is a polymer compound include deposition from a solution containing the polymer compound.

The solvent used for deposition from a solution may be a solvent that dissolves a material used for the hole transport layer. Examples of the solvent include chlorine solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

Application methods from solutions such as spin coating, casting, microgravure coating, gravure coating, bar coating, roll coating, wire bar coating, dip coating, spray coating, screen printing, flexographic printing, offset printing and inkjet printing can be used for deposition from a solution.

The thickness of the hole transport layer may be selected taking drive voltage and luminous efficiency into consideration, but must be a thickness that does not cause generation of pinholes; if the hole transport layer is too thick, the drive voltage of the organic electroluminescence device may be high. Accordingly, the thickness of the hole transport layer is usually 1 nm to 1 µm, preferably 2 nm to 500 nm, more preferably 5 nm to 200 nm.

The luminescent layer of the organic electroluminescence device according to the present embodiment includes the metal complex composition according to the above first embodiment or the complex polymer according to the above second embodiment.

A dopant can be added to the luminescent layer to change the emission wavelength. Examples of the dopant may include anthracene derivatives, perylene derivatives, coumarin derivatives, rubrene derivatives, quinacridone derivatives, squarylium derivatives, porphyrin derivatives, styryl dyes, tetracene derivatives, pyrazolone derivatives, decacyclene and phenoxazone.

The thickness of the luminescent layer may be selected taking drive voltage and luminous efficiency into consideration and is usually 2 to 200 nm.

Examples of the method of forming the luminescent layer include a method of applying a solution containing a constituent material of the luminescent layer on or over a substrate, vacuum evaporation and transfer, and the liquid composition according to the above third embodiment can be suitably used as a solution used for application. Although a solvent illustrated in the description of the above third embodiment may be used as a solvent, the solvent is preferably selected taking the viscosity and deposition properties as well as solubility in the lower layer of the solution into consideration, for example. Printing methods such as spin coating, dip coating, inkjet printing, flexographic printing, gravure printing and slit coating can be used for applying the solution on or over a substrate. Vacuum evaporation can be used in the case of a sublimed low-molecular-weight compound. A method of forming the luminescent layer at a desired location by laser transfer or heat transfer can also be used.

Materials used for the electron transport layer include electron transport materials illustrated in the description of the above first embodiment.

When the electron transport material is a polymer compound, the polymer compound preferably includes an electron transport group (such as an oxadiazole group, a oxathiadiazole group, a pyridyl group, a pyrimidyl group, a pyridazyl group or a triazyl group) as a constitutional unit and/or a substituent of the polymer compound.

Preferred examples of the electron transport material used for the electron transport layer include metal complexes of oxadiazole derivatives, benzoquinone and derivatives thereof, anthraquinone and derivatives thereof and 8-hydroxyquinoline and derivatives thereof; polyquinoline and derivatives thereof, polyquinoxaline and derivatives thereof, polyfluorene and derivatives thereof, and polymer compounds illustrated in the description of the above first embodiment and including at least one constitutional unit selected from the group consisting of a constitutional unit represented by the formula (2) and a constitutional unit represented by the formula (3).

Examples of the method of forming the electron transport layer when the electron transport material is a low-molecular-weight compound include vacuum evaporation from powder, and a method by deposition from a solution or molten state. Examples of the method when the electron transport material is a polymer compound include a method by deposition from a solution or molten state. Deposition from a solution or molten state may be used in combination with a polymer binder. Deposition from a solution may be performed by a method similar to the above method of forming the hole transport layer by deposition from a solution.

The thickness of the electron transport layer may be adjusted taking drive voltage and luminous efficiency into consideration, but must be a thickness that does not cause generation of pinholes; if the electron transport layer is too thick, the drive voltage of the device may be high.
Accordingly, the film thickness of the electron transport layer is usually 1 nm to 1 µm, preferably 2 nm to 500 nm, more preferably 5 nm to 200 nm.

Examples of the electron injection layer depending on the type of the luminescent layer include an electron injection layer made of a Ca monolayer structure; or an electron injection layer made of a laminate structure of a layer formed by one or more selected from the group consisting of metals of Groups IA and IIA of the periodic table excluding Ca, the metals having a work function of 1.5 to 3.0 eV, and oxides, halides and carbonates of the metals, and a Ca layer. Metals of Group IA of the periodic table having a work function of 1.5 to 3.0 eV or oxides, halides or carbonates thereof include lithium, lithium fluoride, sodium oxide, lithium oxide and lithium carbonate. Metals of Group IIA of the periodic table excluding Ca, the metals having a work function of 1.5 to 3.0 eV, and oxides, halides or carbonates thereof include strontium, magnesium oxide, magnesium fluoride, strontium fluoride, barium fluoride, strontium oxide and magnesium carbonate.

The electron injection layer may be formed by vacuum evaporation, sputtering, printing or the like. The thickness of the electron injection layer is preferably 1 nm to 1 µm.

The material of the cathode is preferably a material that has a low work function and easily injects electrons into the luminescent layer, and the material used is a metal such as lithium, sodium, potassium, rubidium, cesium, beryllium, magnesium, calcium, strontium, barium, aluminum, scandium, vanadium, zinc, yttrium, indium, cerium, samarium, europium, terbium or ytterbium, or an alloy of two or more of the above metals, or an alloy of one or more of the above metals and one or more of gold, silver, platinum, copper, manganese, titanium, cobalt, nickel, tungsten and tin, or graphite or a graphite interlayer compound, or the like. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

When the cathode is formed by a laminate structure of two or more layers, it is preferred to combine a layer containing a metal, a metal oxide, a metal fluoride or an alloy thereof as described above with a layer containing a metal such as aluminum, silver or chromium.

The thickness of the cathode may be selected taking electric conductivity and durability into consideration and is usually 10 nm to 10 µm, preferably 20 nm to 1 µm, more preferably 50 nm to 500 nm.

Vacuum evaporation, sputtering, lamination in which a metal thin film is thermocompression bonded, or the like is used for fabricating the cathode. A protecting layer that protects the organic electroluminescence device may be mounted after fabricating the cathode. To use the organic electroluminescence device stably for a long time, a protecting layer and/or a protecting cover are preferably mounted to protect the organic electroluminescence device from outside.

As the protecting layer, a high-molecular-weight compound, a metal oxide, a metal fluoride, a metal boride or the like can be used. As the protecting cover, a metal plate, a glass plate, a plastic plate with a surface subjected to low water permeability treatment, or the like can be used. Examples of the protection include a method of sealing by bonding the protecting cover to a device substrate with a heat-curable resin or photocurable resin. Damage to the device is easily prevented by maintaining the space using a spacer. Oxidation of the cathode can be prevented by filling this space with an inert gas such as nitrogen or argon; further, damage to the device by moisture adsorbed in the manufacture process or a trace amount of moisture infiltrating through the curable resin is easily suppressed by locating a drying agent such as barium oxide in the space. One or more measures among these are preferably employed.

The organic electroluminescence device according to the present embodiment can be used as a planar light source, a display (segment display, dot matrix display), a backlight of a liquid crystal display, or the like. To achieve planar light emission using the organic electroluminescence device according to the present embodiment, a planar anode and a planar cathode may be placed overlappingly. Methods of achieving patterned light emission include a method of locating a mask provided with a patterned window on the surface of the planar organic electroluminescence device, a method of forming the organic layer in the nonluminescent part extremely thick to render this part substantially nonluminescent, or a method of forming either the anode or the cathode or both electrodes in a patterned shape. A segment-type display device that can display numbers, characters, simple symbols and the like is realized by forming a pattern by any of these methods and placing several electrodes so that the electrodes can be independently turned on/off. Further, to provide a dot matrix device, the anode and the cathode may both be formed in a stripe shape and placed perpendicular to each other. Partial color display or multicolor display is possible by a method of applying multiple types of polymer compounds emitting light with different colors to different areas or a method of using a color filter or a fluorescence conversion filter. The dot matrix device can be passively driven or can be actively driven in combination with TFT or the like. These display devices can be used as displays for computers, televisions, personal digital assistants, cellular phones, car navigation systems, video camera viewfinders and the like. Further, the planar organic electroluminescence device is a self-luminous thin type and can be suitably used as a planar light source for a backlight of a liquid crystal display, a planar illumination light source, or the like. In addition, the device can also be used as a curved light source or display if a flexible substrate is used.

### Examples

The present invention will be further described specifically below with reference to Examples and Comparative Examples; however, the present invention is not limited to the following Examples in any way.

### (Number average molecular weight and weight average molecular weight)

In the following Examples and Comparative Examples, the polystyrene-equivalent number average molecular weight (Mn) and the polystyrene-equivalent weight average molecular weight (Mw) were determined by size exclusion chromatography (SEC) (manufactured by Shimadzu: LC-10Avp). The polymer compound to be measured was dissolved in tetrahydrofuran at a concentration of about 0.05 wt% and injected into SEC at 50 µL. Tetrahydrofuran was used as the mobile phase of SEC and allowed to flow at a flow rate of 0.6 mL/min. Two TSKgel SuperHM-H columns (manufactured by Tosoh) and one TSKgel SuperH2000 column (manufactured by Tosoh) were connected in series as columns. A differential refractometer (manufactured by Shimadzu, trade name: RID-10A) was used as the detector.

### (¹H-NMR.)

In Examples, NMR measurement of monomers was performed under room temperature conditions using deuterated chloroform as the measurement solvent.

In the following Synthetic Examples, Examples and Comparative Examples, compounds (A) to (H) and metal complexes (HK012), (HK013) and (HK016) to (HK018) refer to compounds or metal complexes represented by the following structural formulas, respectively.

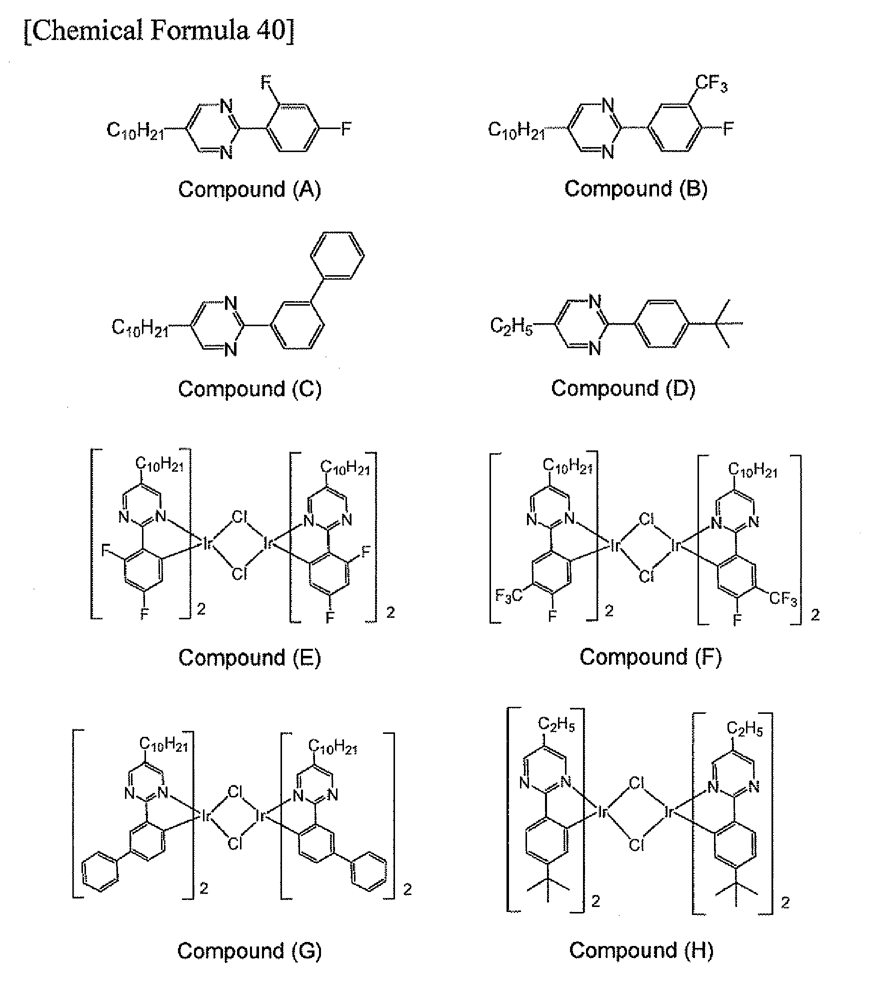

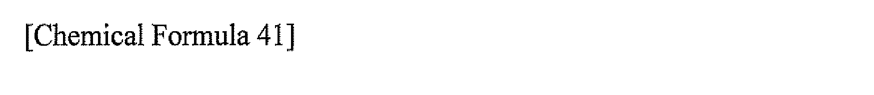

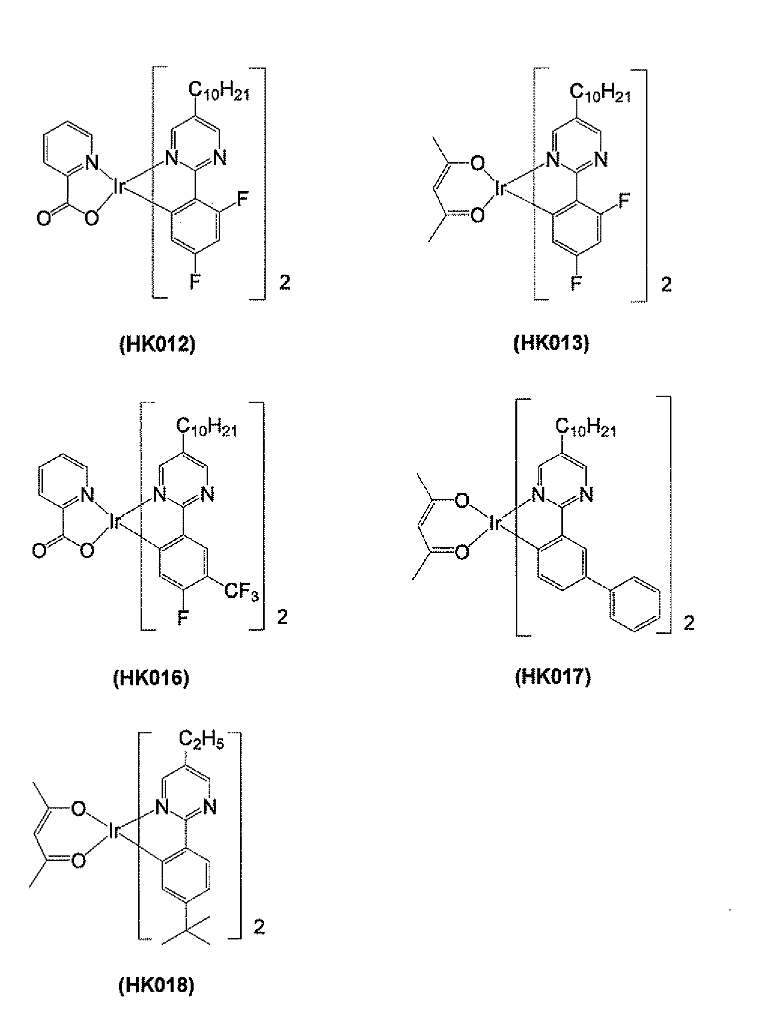

### [Synthetic Example 1; Synthesis of metal complex (HK012)]

### <Step 1; Synthesis of compound (A)>

3.89 g of 2-chloro-5-n-decylpyrimidine, 2.65 g of 2,4-difluorophenylboronic acid, 35 ml of 1,2-dimethoxyethane and 42 ml of a 2 M aqueous potassium carbonate solution were placed in a two-necked flask to prepare a solution. This solution was bubbled with argon gas for 20 minutes, after which 0.88 g of a tetrakistriphenylphosphine(0)-palladium complex was placed and the solution was heated and refluxed using an oil bath in an argon atmosphere for 16 hours. The organic layer was separated and collected, and was separated and purified by silica gel chromatography (eluent: mixed solvent of dichloromethane and hexane) to give 4.1 g of compound (A). The results of ¹H-NMR analysis of the resulting compound (A) are shown below.
¹H-NMR (400 MHz/CDCl₃): δ 8.66 (s, 2H), 8.08-8.15 (m, 1H), 6.91-7.00 (m, 2H), 2.63 (t, 2H), 1.18-1.68 (m, 16H), 0.88 (t, 3H).

### <Step 2; Synthesis of compound (E)>

800 mg of iridium trichloride n-hydrate, 1.58 g of compound (A), 64 ml of 2-ethoxyethanol and 22 ml of water were placed in a two-necked flask and heated and refluxed in an argon atmosphere for 14 hours. The reaction solution was cooled to room temperature, after which water was added and the generated solid was filtered to give compound (E). The isolation yield was 57%. The results of ¹H-NMR analysis of compound (E) are shown below.
¹H-NMR (400 MHz/CDCl₃): δ 9.03 (s, 4H), 8.79 (s, 4H), 6.42 (t, 4H), 5.25 (d, 4H), 2.52 (m, 4H), 2.11 (m, 4H), 1.18-1.70 (m, 64H), 0.87 (t, 12H).

### <Step 3; Synthesis of metal complex (HK012)>

111 mg of compound (E), 45 mg of sodium picolinate and 40 ml of 2-ethoxyethanol were placed in a recovery flask and irradiated with microwaves (2450 MHz) in an argon atmosphere for 10 minutes. The reaction solution was cooled to room temperature, and the solvent was then concentrated under reduced pressure to give a solid. This solid was recrystallized from dichloromethane-hexane to give metal complex (HK012). The isolation yield was 74%. The results of ¹H-NMR analysis of metal complex (HK012) are shown below.
¹H-NMR (400 MHz/CDCl₃): δ 8.68-8.72 (m, 3H), 8.36 (d, 1H), 8.01 (t, 1H), 7.83 (d, 1H), 7.49 (dd, 1H), 7.26 (d, 1H), 6.54 (dd, 1H), 6.47 (dd, 1H), 5.83 (d, 1H), 5.60 (d, 1H), 2.60-2.67 (m, 2H), 2.39-2.48 (m, 2H), 1.23-1.60 (m, 32H), 0.88 (t, 6H).

### [Synthetic Example 2; Synthesis of metal complex (HK013)]

250 mg of compound (E) obtained in a manner similar to that of Synthetic Example 1, 70.3 mg of acetylacetone, 149 mg of sodium carbonate and 50 ml of 2-ethoxyethanol were placed in a recovery flask and irradiated with microwaves (2450 MHz) in an argon atmosphere for 30 minutes. The reaction solution was cooled to room temperature, and the solvent was then concentrated under reduced pressure to give a solid. This solid was separated and purified by silica gel chromatography (eluent: mixed solvent of dichloromethane and hexane) to give metal complex (HK013) in a yield of 48%. The results of ¹H-NMR analysis of the resulting metal complex (HK013) are shown below.
¹H-NMR (400 MHz/CDCl₃): δ 8.73 (d, 2H), 8.38 (d, 2H), 6.40 (dd, 2H), 5.71 (d, 2H), 5.26 (s, 1H), 2.69 (t, 4H), 1.18-1.82 (m, 38H), 0.88 (t, 6H).

### [Synthetic Example 3; Synthesis of metal complex (HK016)]

### <Step 1; Synthesis of compound (B)>

2.5 g of 2-chloro-5-n-decylpyrimidine, 2.24 g of 4-fluoro-3-(trifluoromethyl)phenylboronic acid, 22 ml of 1,2-dimethoxyethane and 26 ml of a 2 M aqueous potassium carbonate solution were placed in a two-necked flask to prepare a solution. This solution was bubbled with argon gas for 20 minutes, and 0.57 g of a tetrakistriphenylphosphine(0)-palladium complex was then placed. The solution obtained in this manner was heated and refluxed using an oil bath in an argon atmosphere for 14 hours. The organic layer was separated and collected, and was separated and purified by silica gel chromatography (eluent: mixed solvent of dichloromethane and hexane) to give 2.50 g of compound (B). The results of ¹H-NMR analysis of the resulting compound (B) are shown below.
¹H-NMR (400 MHz/CDCl₃): δ 8.73 (d, 1H), 8.61-8.65 (m, 3H), 7.30 (d, 1H), 2.64 (t, 2H), 1.18-1.70 (m, 16H), 0.88 (t, 3H).

### <Step 2; Synthesis of compound (F)>

1 g of iridium trichloride n-hydrate, 2.28 g of compound (B), 80 ml of 2-ethoxyethanol and 28 ml of water were placed in a two-necked flask and heated and refluxed in an argon atmosphere for 14 hours. The reaction solution was cooled to room temperature, after which water was added and the generated solid was filtered to give compound (F). The isolation yield was 55%. The results of ¹H-NMR analysis of compound (F) are shown below.
¹H-NMR (400 MHz/CDCl₃): δ 9.07 (s, 4H), 8.79 (s, 4H), 8.29 (d, 4H), 5.64 (d, 4H), 2.59 (m, 4H), 2.17 (m, 4H), 1.18-1.70 (m, 64H), 0.87 (t, 12H).

### <Step 3; Synthesis of metal complex (HK016)>

200 mg of compound (F), 246 mg of sodium picolinate and 100 ml of 2-ethoxyethanol were placed in a recovery flask and irradiated with microwaves (2450 MHz) in an argon atmosphere for 10 minutes. The reaction solution was cooled to room temperature, and the solvent was then concentrated under reduced pressure to give a solid. This solid was recrystallized from dichloromethane-hexane to give metal complex (HK016). The isolation yield was 56%. The results of ¹H-NMR analysis of metal complex (HK016) are shown below.
¹H-NMR (400 MHz/CDCl₃): δ 8.65-8.70 (m, 3H), 8.37 (d, 1H), 8.29 (d, 1H), 8.27 (d, 1H), 8.02 (t, 1H), 7.80 (d, 1H), 7.52 (t, 1H), 7.26 (d, 1H), 6.15 (d, 1H), 5.92 (d, 1H), 2.63-2.67 (m, 2H), 2.45-2.49 (m, 2H), 1.25-1.63 (m, 32H), 0.88 (t, 6H).

### [Synthetic Example 4; Synthesis of metal complex (HK017)]

### <Step 1; Synthesis of compound (C)>

2.5 g of 2-chloro-5-n-decylpyrimidine, 2.14 g of 3-biphenylboronic acid, 22 ml of 1,2-dimethoxyethane and 27 ml of a 2 M aqueous potassium carbonate solution were placed in a two-necked flask to prepare a solution. This solution was bubbled with argon gas for 20 minutes, and 0.57 g of a tetrakistriphenylphosphine(0)-palladium complex was then placed. The solution obtained in this manner was heated and refluxed using an oil bath in an argon atmosphere for 14 hours. The organic layer was separated and collected, and was separated and purified by silica gel chromatography (eluent: mixed solvent of dichloromethane and hexane) to give 2.52 g of compound (C). The results of ¹H-NMR analysis of compound (C) are shown below.
¹H-NMR (400 MHz/CDCl₃): δ 8.69 (s, 1H), 8.64 (s, 2H), 8.40 (d, 1H), 7.71 (d, 3H), 7.55 (t, 1H), 7.46 (t, 2H), 7.36 (t, 1H), 2.62 (t, 2H), 1.18-1.70 (m, 16H), 0.88 (t, 3H).

### <Step 2; Synthesis of compound (G)>

1 g of iridium trichloride n-hydrate, 2.21 g of compound (C), 80 ml of 2-ethoxyethanol and 28 ml of water were placed in a two-necked flask and heated and refluxed in an argon atmosphere for 14 hours. The reaction solution was cooled to room temperature, after which water was added and the generated solid was filtered to give compound (G). The isolation yield was 60%. The results of ¹H-NMR analysis of compound (G) are shown below.
¹H-NMR (400 MHz/CDCl₃): δ 9.25 (d, 4H), 8.71 (d, 4H), 8.18 (d, 4H), 7.50 (d, 8H), 7.32 (t, 8H), 7.23 (t, 4H), 6.98 (d, 4H), 6.04 (d, 4H), 2.54 (m, 4H), 2.19 (m, 4H), 1.18-1.70 (m, 64H), 0.86 (t, 12H).

### <Step 3; Synthesis of metal complex (HK017)>

600 mg of compound (G), 310 mg of acetylacetone, 328 mg of sodium carbonate and 300 ml of 2-ethoxyethanol were mixed and reacted at 100°C in an argon atmosphere for 16 hours. The reaction solution was cooled to room temperature, and the solvent was then concentrated under reduced pressure to give a solid. This solid was separated and purified by silica gel chromatography (eluent: mixed solvent of dichloromethane and hexane) to give metal complex (HK017) in a yield of 23%. The results of ¹H-NMR analysis of metal complex (HK017) are shown below.
¹H-NMR (400 MHz/CDCl₃): δ 8.65 (d, 2H), 8.52 (d, 2H), 8.21 (d, 2H), 7.57 (d, 4H), 7.34 (t, 4H), 7.23 (t, 2H), 7.08 (d, 2H), 6.43 (d, 2H), 5.25 (s, 1H), 2.71 (t, 4H), 1.18-1.83 (m, 38H), 0.87 (t, 6H).

### [Synthetic Example 5; Synthesis of metal complex (HK018)]

### <Step 1; Synthesis of compound (D)>

5 g of 2-chloro-5-ethylpyrimidine, 6.87 g of 4-tert-butylphenylboronic acid, 40 ml of 1,2-dimethoxyethane and 48 ml of a 2 M aqueous potassium carbonate solution were placed in a two-necked flask to prepare a solution. This solution was bubbled with argon gas for 20 minutes, and 2.0 g of a tetrakistriphenylphosphine(0)-palladium complex was then placed. The solution obtained in this manner was heated and refluxed using an oil bath in an argon atmosphere for 16 hours. The organic layer was separated and collected, and was separated and purified by silica gel chromatography (eluent: mixed solvent of dichloromethane and hexane) to give 4.3 g of compound (D). The results of ¹H-NMR analysis of compound (D) are shown below.
¹H-NMR (400 MHz/CDCl₃): δ 8.63 (s, 2H), 8.33 (d, 2H), 7.50 (d, 2H), 2.66 (q, 2H), 1.37 (s, 9H), 1.30 (t, 3H).

### <Step 2; Synthesis of compound (H)>

1 g of iridium trichloride n-hydrate, 1.44 g of compound (D), 80 ml of 1-ethoxyethanol and 28 ml of water were placed in a two-necked flask and heated and refluxed in an argon atmosphere for 14 hours. The reaction solution was cooled to room temperature, after which water was added and the generated solid was filtered to give compound (H). The isolation yield was 92%. The results of ¹H-NMR analysis of compound (H) are shown below.
¹H-NMR (400 MHz/CDCl₃): δ 9.28 (d, 4H), 8.65 (d, 4H), 7.78 (d, 4H), 6.89 (d, 4H), 5.97 (d, 4H), 2.50 (m, 4H), 2.20 (m, 4H), 1.24 (t, 12H), 0.97 (s, 36H).

### <Step 3; Synthesis of metal complex (HK018)>

300 mg of compound (H), 212 mg of acetylacetone, 225 mg of sodium carbonate and 120 ml of 2-ethoxyethanol were mixed and reacted at 100°C in an argon atmosphere for 16 hours. The reaction solution was cooled to room temperature, and the solvent was then concentrated under reduced pressure to give a solid. This solid was separated and purified by silica gel chromatography (eluent: mixed solvent of dichloromethane and hexane) to give metal complex (HK018) in a yield of 37%. The results of ¹H-NMR analysis of metal complex (HK018) are shown below.
¹H-NR4R (400 MHz/CDCl₃): δ 8.59 (d, 2H), 8.50 (d, 2H), 7.79 (d, 2H), 6.91 (d, 2H), 6.23 (d, 2H), 5.20 (s, 1H), 2.66-2.78 (m, 4H), 1.81 (s, 6H), 1.33 (t, 6H), 1.07 (s, 18H).

### [Synthetic Example 6; Synthesis of electron transport material (ET-A)]

Electron transport material (ET-A) was synthesized according to the following reaction scheme. 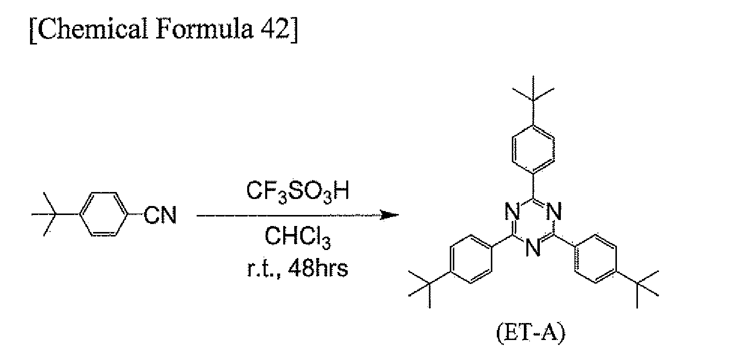 Specifically, 4-tert-butylbenzonitrile (10.0 g) and dehydrated chloroform (75 ml) were weighed in a round-bottom flask, and the atmosphere in the flask was replaced with nitrogen gas. Trifluoromethanesulfonic acid (11 ml) was added thereto with stirring, and the mixture was stirred at room temperature for 48 hours.
After completion of the reaction, the reaction solution was cooled to room temperature and then washed with 10 wt% aqueous ammonia (100 ml) once and ion exchange water (200 ml) once. The extracted organic layer was dehydrated with magnesium sulfate, and the solvent was distilled off under reduced pressure. The resulting residue was repeatedly recrystallized from a chloroform/hexane mixed solvent to give 4.2 g of 2,4,6-tris(4-tert-butylphenyl)-1,3,5-triazine (hereinafter called "electron transport material (ET-A)").
The results of ¹H-NMR analysis of electron transport material (ET-A) are shown below.
¹H-NMR (300 MHz, CDCl₃) δ 1.40 (s, 27H), 7.59 (d, J = 7.5Hz, 6H), 8.68 (d, J=7.5Hz 6H).

### [Synthetic Example 7; Synthesis of electron transport material (ET-B)]

Electron transport material (ET-B) was synthesized according to the following reaction scheme. 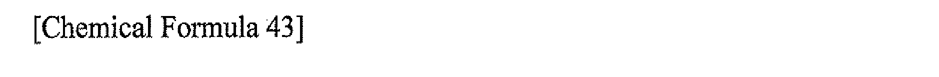 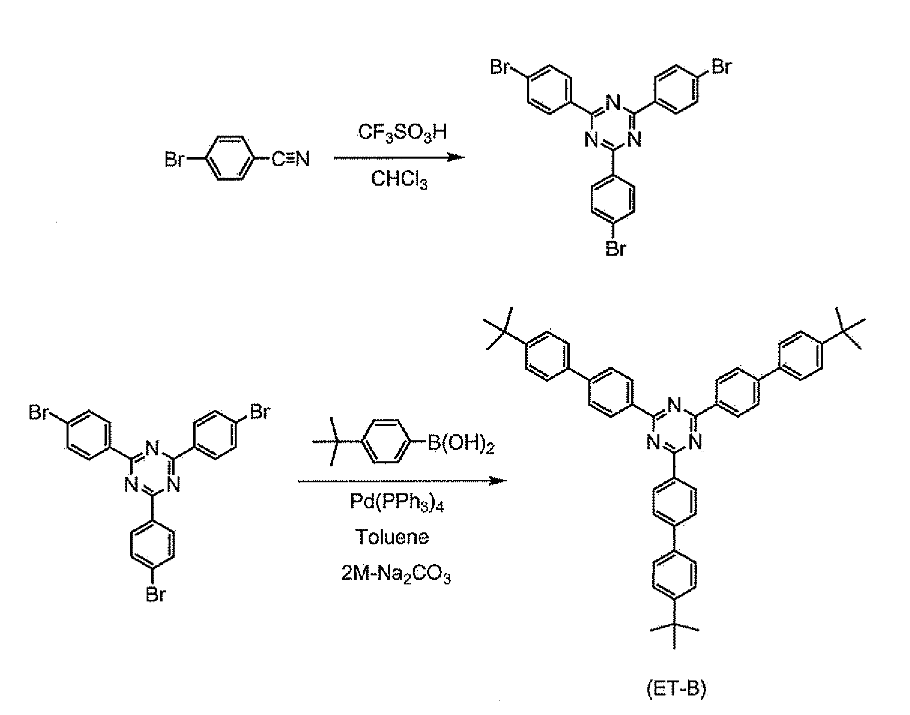 Specifically, 100 g (0.653 mol) of trifluoromethanesulfonic acid was mixed and stirred at room temperature in a nitrogen atmosphere. A solution of 61.93 g (0.327 mol) of 4-bromobenzonitrile in 851 ml of dehydrated chloroform was added dropwise to the reaction solution.
The resulting solution was warmed to 95 °C, stirred with heating and then cooled to room temperature, and a diluted aqueous ammonia solution was added thereto in an ice bath to generate a solid. This solid was separated by filtration, washed with water and then with diethyl ether and dried under reduced pressure to give 47.8 g of white crystals.
Next, 8.06 g (14.65 mol) of the white crystals, 9.15 g (49.84 mol) of 4-t-butylphenylboronic acid, 1.54 g (1.32 mol) of Pd(PPh₃)₄, 500 ml of toluene previously bubbled with nitrogen and 47.3 ml of ethanol previously bubbled with nitrogen were mixed, stirred, heated and refluxed in a nitrogen atmosphere. 47.3 ml of a 2 M aqueous sodium carbonate solution previously bubbled with nitrogen was added dropwise to the reaction solution, which was further heated and refluxed. The reaction solution was left to cool and then partitioned, the aqueous layer was removed, and the organic layer was sequentially washed with dilute hydrochloric acid and water and partitioned. The organic layer was dried over anhydrous magnesium sulfate, filtered and concentrated. The resulting crude product was allowed to pass through a silica gel column, and acetonitrile was added to the resulting filtrate to give crystals. The crystals were dried under reduced pressure to give electron transport material (ET-B) as 8.23 g white crystals. The results of ¹H-NMR analysis of electron transport material (ET-B) are shown below.
¹H-NMR (270 MHz/CDCl₃): δ 1.39 (s, 27H), 7.52 (d, 6H), 7.65 (d, 6H), 7.79 (d, 6H), 8.82 (d, 6H).

### [Synthetic Example 8; Synthesis of polymer compound (CP1)]

5.20 g of 2,7-bis(1,3,2-dioxaborolan-2-yl)-9,9-dioctylfluorene, 5.42 g of 4,4'-dibromo-4"-sec-butyltriphenylamine, 2.2 mg of palladium acetate, 15.1 mg of tris(2-methylphenyl)phosphine, 0.91 g of trioctylmethylammonium chloride (trade name: Aliquat 336, manufactured by Aldrich) and 70 ml of toluene were mixed and heated to 105°C in an inert atmosphere. 19 ml of a 2 M aqueous sodium carbonate solution was added dropwise to the reaction solution, which was refluxed for four hours. After the reaction, 121 mg of benzeneboronic acid was added, followed by refluxing for further three hours. An aqueous sodium N,N-diethyldithiocarbamate trihydrate solution was then added, followed by stirring at 80°C for two hours. After cooling, the reaction solution was washed with 60 ml of water three times, 60 ml of a 3 wt% aqueous acetic acid solution four times and 60 ml of water three times, and the resulting toluene solution was purified by allowing it to pass through an alumina column and a silica gel column. The resulting toluene solution was added dropwise to about 3000 ml of methanol and stirred, and the resulting precipitate was then collected by filtration and dried to give 5.25 g of polymer compound (CP1). The polystyrene-equivalent number average molecular weight (Mn) and weight average molecular weight (Mw) of polymer compound (CP1) were Mn = 1.2 × 10⁵ and Mw = 2.6 × 10⁵, and the glass transition temperature was 89°C. Polymer compound (CP1) is assumed to be an alternating copolymer having the following constitutional units and molar ratio based on the monomer charge ratio.

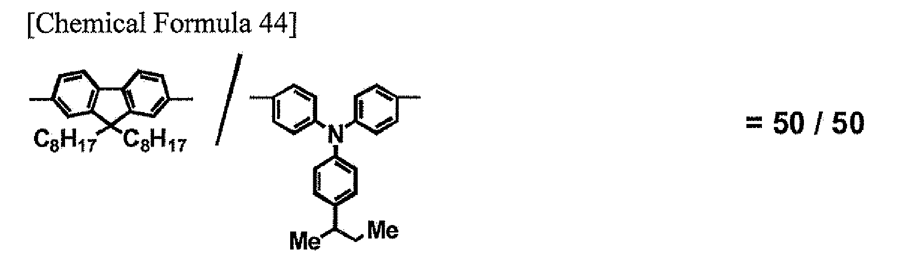

### [Synthetic Example 9; Synthesis of polymer compound (P1) as charge transport material]

2,5-Di-hexyl-1,4-benzenediboric acid bis(pinacol) ester (3.13 g), 2,7-dibromo-9,9-dioctylfluorene (3.47 g) and 80.0 mL of toluene were mixed and stirred with heating in an inert gas atmosphere. Palladium(II) acetate (2.2 mg) and tris(2-methoxyphenyl)phosphine (13.4 mg) were added to the reaction solution, which was heated to 100°C, and a 20 wt% aqueous tetraethylammonium hydroxide solution (22.0 ml) was then added dropwise, followed by refluxing for 4.5 hours. After the reaction, phenylboric acid (78 mg), palladium(II) acetate (2.2 mg), tris(2-methoxyphenyl)phosphine (13.4 mg) and a 20 wt% aqueous tetraethylammonium hydroxide solution (22.0 ml) were added thereto, and the mixture was refluxed for further 15 hours. The aqueous layer was removed from the reaction solution, and a 0.2 M aqueous sodium diethyldithiocarbamate solution (70 ml) was then added, followed by stirring at 85°C for two hours. The reaction solution was cooled to room temperature and washed with water (82 ml) three times, a 3 wt% aqueous acetic acid solution (82 ml) three times and water (82 ml) three times, and the resulting toluene solution was added dropwise to methanol (1500 ml) to generate a precipitate, after which the precipitate was collected by filtration and dried. The sufficiently dried precipitate (solid) was dissolved in 400 ml of toluene and purified by allowing it to pass through a column packed with silica gel and alumina. The resulting toluene solution was added dropwise to methanol (1500 ml) to generate a precipitate, and the precipitate was collected by filtration and dried. The yield of the precipitate (hereinafter called "polymer compound (P1)" was 3.52 g. The polystyrene-equivalent number average molecular weight and weight average molecular weight of polymer compound (P1) were Mn = 3.1 × 10⁵ and Mw = 8.5 × 10⁵, respectively. Polymer compound (P1) is assumed to be an alternating copolymer having the following constitutional units and molar ratio based on the monomer charge ratio.

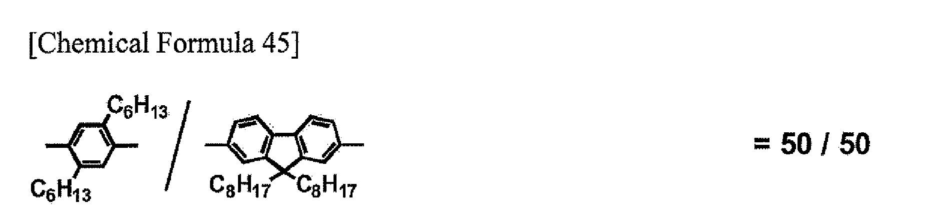

### [Example 1; Fabrication of organic electroluminescence device 1]

A suspension of poly(3,4)ethylenedioxythiophene/polystyrenesulfonic acid (manufactured by H.C. Stark, trade name: CLEVIOS P AI4083) (hereinafter called "CLEVIOS P") was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1) and metal complex (HK017) were dissolved in xylene (manufactured by Kanto Kagaku: electronic grade (EL grade)) at a concentration of 0.9 wt% (on a weight basis, polymer compound (P1)/metal complex (HK017) = 95/5). The resulting xylene solution was placed on the polymer compound (CP1) film, and luminescent layer 1 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 1 film at about 5 nm and aluminum was then vacuum evaporated on the barium layer at about 60 nm as the cathode. After the vacuum evaporation, organic electroluminescence device 1 was fabricated by sealing using a glass substrate.
As voltage was applied to organic electroluminescence device 1, green electroluminescence (EL) was observed. The luminous efficiency at a luminance of 1000 cd/m² was 6.4 cd/A, and the voltage was 19.1 V and the external quantum yield was 1.8% at that time. The results obtained are shown in Table 1.

### [Example 2; Fabrication of organic electroluminescence device 2]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-A) and metal complex (HK017) were dissolved in xylene (manufactured by Kanto Kagaku: electronic grade (EL grade)) at a concentration of 0.9 wt% (on a weight basis, polymer compound (P1)/electron transport material (ET-A)/metal complex (HK017) = 85/10/5). The resulting xylene solution was placed on the polymer compound (CP1) film, and luminescent layer 2 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 2 film at about 5 nm and aluminum was then vacuum evaporated on the barium layer at about 60 nm as the cathode. After the vacuum evaporation, organic electroluminescence device 2 was fabricated by sealing using a glass substrate.
As voltage was applied to organic electroluminescence device 2, green electroluminescence (EL) was observed. The luminous efficiency at a luminance of 1000 cd/m² was 8.1 cd/A, and the voltage was 17.3 V and the external quantum yield was 2.1% at that time. The results obtained are shown in Table 1.

### [Example 3; Fabrication of organic electroluminescence device 3]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-B) and metal complex (HK017) were dissolved in xylene (manufactured by Kanto Kagaku: electronic grade (EL grade)) at a concentration of 0.9 wt% (on a weight basis, polymer compound (P1)/electron transport material (ET-B)/metal complex (HK017) = 85/10/5). The resulting xylene solution was placed on the polymer compound (CP1) film, and luminescent layer 3 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 3 film at about 5 nm and aluminum was then vacuum evaporated on the barium layer at about 60 nm as the cathode. After the vacuum evaporation, organic electroluminescence device 3 was fabricated by sealing using a glass substrate.
As voltage was applied to organic electroluminescence device 3, green electroluminescence (EL) was observed. The luminous efficiency at a luminance of 1000 cd/m² was 16.5 cd/A, and the voltage was 14.3 V and the external quantum yield was 4.5% at that time. The results obtained are shown in Table 1.

### [Example 4; Fabrication of organic electroluminescence device 4]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1) and metal complex (HK018) were dissolved in xylene (manufactured by Kanto Kagaku: electronic grade (EL grade)) at a concentration of 0.9 wt% (on a weight basis, polymer compound (P1)/metal complex (HK018) = 95/5). The resulting xylene solution was placed on the polymer compound (CP1) film, and luminescent layer 4 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis).
After reducing the pressure to 1.0 × 10⁻⁴ Pa or less, barium was vacuum evaporated on the luminescent layer 4 film at about 5 nm and aluminum was then vacuum evaporated on the barium layer at about 60 nm as the cathode. After the vacuum evaporation, organic electroluminescence device 4 was fabricated by sealing using a glass substrate.
As voltage was applied to organic electroluminescence device 4, green electroluminescence (EL) was observed. The luminous efficiency at a luminance of 1000 cd/m² was 10.1 cd/A, and the voltage was 17.1 V and the external quantum yield was 2.8% at that time. The results obtained are shown in Table 1.

### [Example 5; Fabrication of organic electroluminescence device 5]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-A) and metal complex (HK018) were dissolved in xylene (manufactured by Kanto Kagaku: electronic grade (EL grade)) at a concentration of 0.9 wt% (on a weight basis, polymer compound (P1)/electron transport material ET-A/metal complex (HK018) = 85/10/5). The resulting xylene solution was placed on the polymer compound (CP1) film, and luminescent layer 5 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 5 film at about 5 nm and aluminum was then vacuum evaporated on the barium layer at about 60 nm as the cathode. After the vacuum evaporation, organic electroluminescence device 5 was fabricated by sealing using a glass substrate.
As voltage was applied to organic electroluminescence device 5, green electroluminescence (EL) was observed. The luminous efficiency at a luminance of 1000 cd/m² was 13.1 cd/A, and the voltage was 15.6 V and the external quantum yield was 3.6% at that time. The results obtained are shown in Table 1.

### [Example 6; Fabrication of organic electroluminescence device 6]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-B) and metal complex (HK018) were dissolved in xylene (manufactured by Kanto Kagaku: electronic grade (EL grade)) at a concentration of 0.9 wt% (on a weight basis, polymer compound (P1)/electron transport material (ET-B)/metal complex (HK018) = 85/10/5). The resulting xylene solution was placed on the polymer compound (CP1) film, and luminescent layer 6 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.4 × 10⁻⁴ Pa or less, barium was vacuum evaporated on the luminescent layer 6 film at about 5 nm and aluminum was then vacuum evaporated on the barium layer at about 60 nm as the cathode. After the vacuum evaporation, organic electroluminescence device 6 was fabricated by sealing using a glass substrate.
As voltage was applied to organic electroluminescence device 6, green electroluminescence (EL) was observed. The luminous efficiency at a luminance of 1000 cd/m² was 19.1 cd/A, and the voltage was 15.3 V and the external quantum yield was 5.3% at that time. The results obtained are shown in Table 1.

### [Comparative Example 1; Fabrication of organic electroluminescence device 7]

A suspension of CLEVIOS P was placed on a glass substrate having an ITO film formed with a thickness of 150 nm by sputtering, deposited to have a thickness of about 65 nm. by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1) and an iridium complex represented by the following formula: 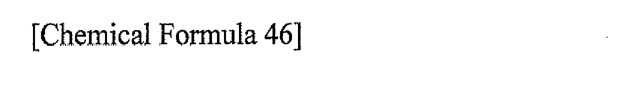 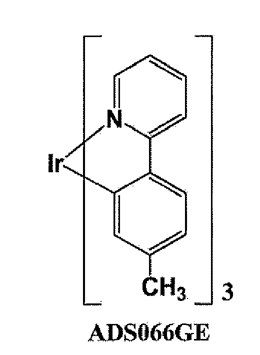 (manufactured by American Dye Source, Inc., trade name: ADS066GE, hereinafter called "ADS066GE") were dissolved in xylene (manufactured by Kanto Kagaku: electronic grade (EL grade)) at a concentration of 0.9 wt% (on a weight basis, polymer compound (P1)/ADS066GE = 95/5). The resulting xylene solution was placed on the polymer compound (CP1) film, and luminescent layer 7 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 7 film at about 5 nm and aluminum was then vacuum evaporated on the barium layer at about 60 nm as the cathode. After the vacuum evaporation, organic electroluminescence device 7 was fabricated by sealing using a glass substrate.
As voltage was applied to organic electroluminescence device 7, green electroluminescence (EL) was observed. The luminous efficiency at a luminance of 1000 cd/m² was 2.6 cd/A, and the voltage was 16.6 V and the external quantum yield was 0.8% at that time. The results obtained are shown in Table 1.

### [Comparative Example 2; Fabrication of organic electroluminescence device 8]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-A) and ADS066GE were dissolved in xylene (manufactured by Kanto Kagaku: electronic grade (EL grade)) at a concentration of 0.9 wt% (on a weight basis, polymer compound (P1)/electron transport material (ET-A)/ADS066GE = 85/10/5). The resulting xylene solution was placed on the polymer compound (CP1) film, and luminescent layer 8 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 8 film at about 5 nm and aluminum was then vacuum evaporated on the barium layer at about 60 nm as the cathode. After the vacuum evaporation, organic electroluminescence device 8 was fabricated by sealing using a glass substrate.
As voltage was applied to organic electroluminescence device 8, green electroluminescence (EL) was observed. The luminous efficiency at a luminance of 1000 cd/m² was 6.1 cd/A, and the voltage was 15.7 V and the external quantum yield was 1.9% at that time. The results obtained are shown in Table 1.

### [Comparative Example 3; Fabrication of organic electroluminescence device 9]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, polymer compound (P1), electron transport material (ET-B) and ADS066GE were dissolved in xylene (manufactured by Kanto Kagaku: electronic grade (EL grade)) at a concentration of 0.9 wt% (on a weight basis, polymer compound (P1)/electron transport material (ETB)/ADS066GE = 85/10/5). The resulting xylene solution was placed on the polymer compound (CP1) film, and luminescent layer 9 was deposited to have a thickness of about 80 nm by spin coating. Thereafter, the layer was dried at 130°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 9 film at about 5 nm and aluminum was then vacuum evaporated on the barium layer at about 60 nm as the cathode. After the vacuum evaporation, organic electroluminescence device 9 was fabricated by sealing using a glass substrate.
As voltage was applied to organic electroluminescence device 9, green electroluminescence (EL) was observed. The luminous efficiency at a luminance of 1000 cd/m² was 9.8 cd/A, and the voltage was 18.1 V and the external quantum yield was 3.0% at that time. The results obtained are shown in Table 1. ,

**[Table 1] .**

| | Metal complex | Charge transport material | | Composition ratio | Luminous efficiency (cd/A) | Drive voltage (V) | External quantum yield (%) |
|---|---|---|---|---|---|---|---|
| | | Polymer compound | Electron transport material | | | | |
| Example 1 | HK017 | P1 | - | 5/95 | 6.4 | 19.1 | 1.8 |
| Example 2 | HK017 | P 1 | ET-A | 5/85/10 | 8.1 | 17.3 | 2.1 |
| Example 3 | HK017 | P1 | ET-B | 5/85/10 | 16.5 | 14.3 | 4.5 |
| Example 4 | HK018 | P1 | - | 5/95 | 10.1 | 17.1 | 2.8 |
| Example 5 | HK018 | P1 | ET-A | 5/85/10 | 13.1 | 15.6 | 3.6 |
| Example 6 | HK018 | P1 | ET-B | 5/85/10 | 19.1 | 15.3 | 5.3 |
| Comparative Examples 1 | ADS066GE | P1 | - | 5/95 | 2.6 | 16.6 | 0.8 |
| Comparative Example 2 | ADS066GE | P1 | ET-A | 5/85/10 | 6.1 | 15.7 | 1.9 |
| Comparative Example 3 | ADS066GE | P1 | ET-B | 5/85/10 | 9.8 | 18.1 | 3.0 |

### [Example 7; Fabrication of organic electroluminescence device 10]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, a charge transport material 4,4'-bis(9-carbazolyl)-biphenyl (manufactured by Dojindo Laboratories, trade name: DCBP, sublimed) (hereinafter called "low-molecular-weight compound (CBP)") and metal complex (HK017) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/metal complex (HK017) = 95/5). The resulting chloroform solution was placed on the polymer compound (CP1) film, and luminescent layer 10 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 10 film at about 5 nm and aluminum was then vacuum evaporated on the barium layer at about 60 nm as the cathode. After the vacuum evaporation, organic electroluminescence device 10 was fabricated by sealing using a glass substrate.
As voltage was applied to organic electroluminescence device 10, green electroluminescence (EL) was observed. The luminous efficiency at a luminance of 1000 cd/m² was 3.9 cd/A, and the voltage was 9.0 V and the external quantum yield was 1.0% at that time. The results obtained are shown in Table 2.

### [Example 8; Fabrication of organic electroluminescence device 11]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (CBP), electron transport material (ET-A) and metal complex (HK017) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/electron transport material (ET-A)/metal complex (HK017) = 85/10/5). The resulting chloroform solution was placed on the polymer compound (CP 1) film, and luminescent layer 11 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 11 film at about 5 nm and aluminum was then vacuum evaporated on the barium layer at about 60 nm as the cathode. After the vacuum evaporation, organic electroluminescence device 11 was fabricated by sealing using a glass substrate.
As voltage was applied to organic electroluminescence device 11, green electroluminescence (EL) was observed. The luminous efficiency at a luminance of 1000 cd/m² was 9.5 cd/A, and the voltage was 7.8 V and the external quantum yield was 1.9% at that time. The results obtained are shown in Table 2.

### [Example 9; Fabrication of organic electroluminescence device 12]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (CBP), electron transport material (ET-B) and metal complex (HK017) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/electron transport material (ET-B)/metal complex (HK017) = 85/10/5). The resulting chloroform solution was placed on the polymer compound (CP1) film, and luminescent layer 12 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 12 film at about 5 nm and aluminum was then vacuum evaporated on the barium layer at about 60 nm as the cathode. After the vacuum evaporation, organic electroluminescence device 12 was fabricated by sealing using a glass substrate.
As voltage was applied to organic electroluminescence device 12, green electroluminescence (EL) was observed. The luminous efficiency at a luminance of 1000 cdlm² was 14.9 cd/A, and the voltage was 7.9 V and the external quantum yield was 4.0% at that time. The results obtained are shown in Table 2.

### [Example 10; Fabrication of organic electroluminescence device 13]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (CBP) and metal complex (HK018) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/metal complex (HK018) = 95/5). The resulting chloroform solution was placed on the polymer compound (CP1) film, and luminescent layer 13 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 13 film at about 5 nm and aluminum was then vacuum evaporated on the barium layer at about 60 nm as the cathode. After the vacuum evaporation, organic electroluminescence device 13 was fabricated by sealing using a glass substrate.
As voltage was applied to organic electroluminescence device 13, green electroluminescence (EL) was observed. The luminous efficiency at a luminance of 1000 cd/m² was 6.2 cd/A, and the voltage was 8.6 V and the external quantum yield was 1.7% at that time. The results obtained are shown in Table 2.

### [Example 11; Fabrication of organic electroluminescence device 14]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (CBP), electron transport material (ET-A) and metal complex (HK018) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/electron transport material (ET-A)/metal complex (HK018) = 85/10/5). The resulting chloroform solution was placed on the polymer compound (CP1) film, and luminescent layer 14 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 14 film at about 5 nm and aluminum was then vacuum evaporated on the barium layer at about 60 nm as the cathode. After the vacuum evaporation, organic electroluminescence device 14 was fabricated by sealing using a glass substrate.
As voltage was applied to organic electroluminescence device 14, green electroluminescence (EL) was observed. The luminous efficiency at a luminance of 1000 cd/m² was 9.3 cd/A, and the voltage was 7.8 V and the external quantum yield was 2.6% at that time. The results obtained are shown in Table 2.

### [Example 12; Fabrication of organic electroluminescence device 15]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (CBP), electron transport material (ET-B) and metal complex (HK018) were dissolved in chloroform (manufactured by Wako Pure Chemical Industries, Ltd.: pure solvent for fluorescence analysis) at a concentration of 0.8 wt% (on a weight basis, low-molecular-weight compound (CBP)/electron transport material (ET-B)/metal complex (HK018) = 85/10/5). The resulting chloroform solution was placed on the polymer compound (CP 1) film, and luminescent layer 15 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 15 film at about 5 nm and aluminum was then vacuum evaporated on the barium layer at about 60 nm as the cathode. After the vacuum evaporation, organic electroluminescence device 15 was fabricated by sealing using a glass substrate.
As voltage was applied to organic electroluminescence device 15, green electroluminescence (EL) was observed. The luminous efficiency at a luminance of 1000 cdlm² was 14.9 cd/A, and the voltage was 7.7 V and the external quantum yield was 4.1% at that time. The results obtained are shown in Table 2.

**[Table 2]**

| | Metal complex | Charge transport material | | Composition ratio | Luminous efficiency (cd/A) | Drive voltage (V) | External quantum yield (%) |
|---|---|---|---|---|---|---|---|
| | | Low-molecular -weight compound | Electron transport material | | | | |
| Example 7 | HK017 | CBP | - | 5/95 | 3.9 | 9.0 | 1.0 |
| Example 8 | HK017 | CBP | ET-A | 5/85/10 | 9.5 | 7.8 | 1.9 |
| Example 9 | HK017 | CBP | ET-B | 5/85/10 | 14.9 | 7.9 | 4.0 |
| Example 10 | HK018 | CBP | - | 5195 6.2 | | 8.6 | 1.7 |
| Example 11 | HK018 | CBP | ET-A | 5/85/10 | 9.3 | 7.8 | 2.6 |
| Example 12 | HK018 | CBP | ET-B | 5/85/10 | 14.9 | 7.7 | 4.1 |

### [Example 13; Fabrication of organic electroluminescence device 16]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, a charge transport material 4,4'-bis(9-carbazolyl)-biphenyl (manufactured by Ohjec, trade name: MCP) (hereinafter called "low-molecular-weight compound (mCP)" and metal complex (HK012) were dissolved in chloroform (manufactured by Wako Pure Chemical Industries, Ltd.: pure solvent for fluorescence analysis) at a concentration of 0.8 wt% (on a weight basis, low-molecular-weight compound (mCP)/metal complex (he012) = 95/5). The resulting chloroform solution was placed on the polymer compound (CP1) film, and luminescent layer 16 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 16 film at about 5 nm and aluminum was then vacuum evaporated on the barium layer at about 60 nm as the cathode. After the vacuum evaporation, organic electroluminescence device 16 was fabricated by sealing using a glass substrate.
As voltage was applied to organic electroluminescence device 16, blue electroluminescence (EL) was observed. The luminous efficiency at a luminance of 100 cd/m² was 0.3 cd/A, and the voltage was 16.6 V and the external quantum yield was 0.1% at that time. The results obtained are shown in Table 3.

### [Example 14; Fabrication of organic electroluminescence device 17]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (mCP), electron transport material (ET-A) and metal complex (HK012) were dissolved in chloroform (manufactured by Wako Pure Chemical Industries, Ltd.: pure solvent for fluorescence analysis) at a concentration of 0.8 wt% (on a weight basis, low-molecular-weight compound (mCP)/electron transport material (ET-A)/luminescent material (HK012) = 85/10/5). The resulting chloroform solution was placed on the polymer compound (CP1) film, and luminescent layer 17 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 17 film at about 5 nm and aluminum was then vacuum evaporated on the barium layer at about 60 nm as the cathode. After the vacuum evaporation, organic electroluminescence device 17 was fabricated by sealing using a glass substrate.
As voltage was applied to organic electroluminescence device 17, blue electroluminescence (EL) was observed. The luminous efficiency at a luminance of 100 cdlm² was 3.8 cd/A, and the voltage was 7.6 V and the external quantum yield was 1.4% at that time. The results obtained are shown in Table 3.

### [Example 15; Fabrication of organic electroluminescence device 18]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVTOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (mCP) and metal complex (HK013) were dissolved in chloroform (manufactured by Wako Pure Chemical Industries, Ltd.: pure solvent for fluorescence analysis) at a concentration of 0.8 wt% (on a weight basis, low-molecular-weight compound (mCP)/metal complex (HK013) = 95/5). The resulting chloroform solution was placed on the polymer compound (CP1) film, and luminescent layer 18 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 18 film at about 5 nm and aluminum was then vacuum evaporated on the barium layer at about 60 nm as the cathode. After the vacuum evaporation, organic electroluminescence device 18 was fabricated by sealing using a glass substrate.
As voltage was applied to organic electroluminescence device 18, blue electroluminescence (EL) was observed. The luminous efficiency at a luminance of 100 cd/m² was 0.7 cd/A, and the voltage was 13.7 V and the external quantum yield was 0.2% at that time. The results obtained are shown in Table 3.

### [Example 16; Fabrication of organic electroluminescence device 19]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (mCP), electron transport material (ET-A) and metal complex (HK013) were dissolved in chloroform (manufactured by Wako Pure Chemical Industries, Ltd.: pure solvent for fluorescence analysis) at a concentration of 0.8 wt% (on a weight basis, low-molecular-weight compound (mCP)lelectron transport material (ET-A)/metal complex (HK013) = 85/10/5). The resulting chloroform solution was placed on the polymer compound (CP1) film, and luminescent layer 19 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 19 film at about 5 nm and aluminum was then vacuum evaporated on the barium layer at about 60 nm as the cathode. After the vacuum evaporation, organic electroluminescence device 19 was fabricated by sealing using a glass substrate.
As voltage was applied to organic electroluminescence device 19, blue electroluminescence (EL) was observed. The luminous efficiency at a luminance of 100 cd/m² was 2.2 cd/A, and the voltage was 8.3 V and the external quantum yield was 0.7% at that time. The results obtained are shown in Table 3.

### [Example 17; Fabrication of organic electroluminescence device 20]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wt%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (mCP) and metal complex (HK016) were dissolved in chloroform (manufactured by Wako Pure Chemical Industries, Ltd.: pure solvent for fluorescence analysis) at a concentration of 0.8 wt% (on a weight basis, low-molecular-weight compound (mCP)/metal complex (HK016) = 95/5). The resulting chloroform solution was placed on the polymer compound (CP1) film, and luminescent layer 20 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 20 film at about 5 nm and aluminum was then vacuum evaporated on the barium layer at about 60 nm as the cathode. After the vacuum evaporation, organic electroluminescence device 20 was fabricated by sealing using a glass substrate.
As voltage was applied to organic electroluminescence device 20, blue electroluminescence (EL) was observed. The luminous efficiency at a luminance of 100 cd/m² was 0.2 cd/A, and the voltage was 14.8 V and the external quantum yield was 0.1% at that time. The results obtained are shown in Table 3.

### [Example 18; Fabrication of organic electroluminescence device 21]

A suspension of CLEVIOS P was placed on a glass substrate having an ITO film formed with a thickness of 150 nm by sputtering, deposited to have a thickness of about 65 nm by spin coating, and dried on a hot plate at 200°C for 10 minutes. Next, polymer compound (CP1) was dissolved in xylene (manufactured by Kanto Kagaku: electronic grade (EL grade)) at a concentration of 0.7 wit%, and the resulting xylene solution was placed on the CLEVIOS P film, deposited to have a thickness of about 20 nm by spin coating, and dried at 180°C for 60 minutes in a nitrogen atmosphere having an oxygen concentration and a moisture concentration of 10 ppm or less (on a weight basis). Next, low-molecular-weight compound (mCP), electron transport material (ET-A) and metal complex (HK016) were dissolved in chloroform (manufactured by Wako Pure Chemical Industries, Ltd.: pure solvent for fluorescence analysis) at a concentration of 0.8 wt% (on a weight basis, low-molecular-weight compound (mCP)/electron transport material (ET-A)/metal complex (HK016) = 85/10/5). The resulting chloroform solution was placed on the polymer compound (CP1) film, and luminescent layer 21 was deposited to have a thickness of about 80 nm by spin coating. Thereafter, the layer was dried at 60°C for 10 minutes in a nitrogen atmosphere having an oxygen concentration and a moisture concentration of 10 ppm or less (on a weight basis). After reducing the pressure to 1.0 × 10⁻⁴ Pa or less, barium was vacuum evaporated on the luminescent layer 21 film at about 5 nm and aluminum was then vacuum evaporated on the barium layer at about 60 nm as the cathode. After the vacuum evaporation, organic electroluminescence device 21 was fabricated by sealing using a glass substrate.
As voltage was applied to organic electroluminescence device 21, blue electroluminescence (EL) was observed. The luminous efficiency at a luminance of 100 cd/m² was 2.4 cd/A, and the voltage was 9.8 V and the external quantum yield was 0.7% at that time. The results obtained are shown in Table 3.

**[Table 3]**

| | Metal complex | Charge transport material | | Composition ratio | Luminous efficiency (cd/A) | Drive voltage (V) | External quantum yield (%) |
|---|---|---|---|---|---|---|---|
| | | Low-molecular -weight compound | Electron transport material | | | | |
| Example 13 | HK012 | mCP | - | 5/95 | 0.3 | 16.6 | 0.1 |
| Example 14 | HK012 | mCP | ET-A | 5/85/10 | 3.8 | 7.6 | 1.4 |
| Examples 15 | HK013 | mCP | - | 5/95 | 0.7 | 13.7 | 0.2 |
| Example 16 | HK013 | mCP | ET-A | 5/85/10 | 2.2 | 8.3 | 0.7 |
| Examples 17 | HK016 | mCP | - | 5/95 | 0.2 | 14.8 | 0.1 |
| Examples 18 | HK016 | mCP | ET-A | 5/85/10 | 2.4 | 9.8 | 0.7 |

## Claims

1. A metal complex composition comprising:
a metal complex comprising a structure represented by the following formula(1); and
a charge transport material, 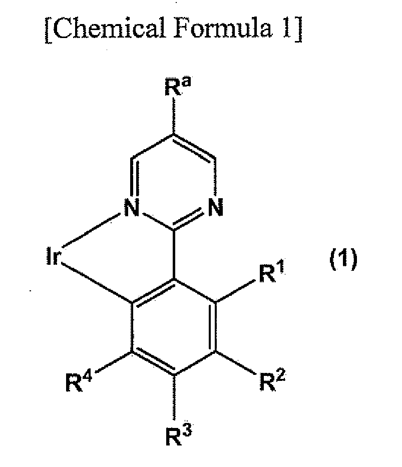 wherein in the formula (1), R^{a} represents an alkyl group having 2 to 30 carbon atoms that may have a substituent, and R¹, R², R³ and R⁴ each independently represent a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, provided that adjacent groups among R¹, R², R³ and R⁴ may be bonded to each other to form a ring structure.

2. The metal complex composition according to claim 1, wherein the charge transport material is a low-molecular-weight organic compound.

3. The metal complex composition according to claim 1, wherein the charge transport material is a polymer compound comprising at least one constitutional unit selected from the group consisting of a constitutional unit represented by the following formula (2) and a constitutional unit represented by the following formula (3),
[Chemical Formula 2] -Ar¹- (2)
wherein in the formula (2), Ar¹ represents an arylene group, a divalent aromatic heterocyclic group, or a divalent group where two or more identical or different groups selected from the group consisting of the arylene groups and the divalent aromatic heterocyclic groups are directly bonded, provided that a group represented by Ar¹ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, 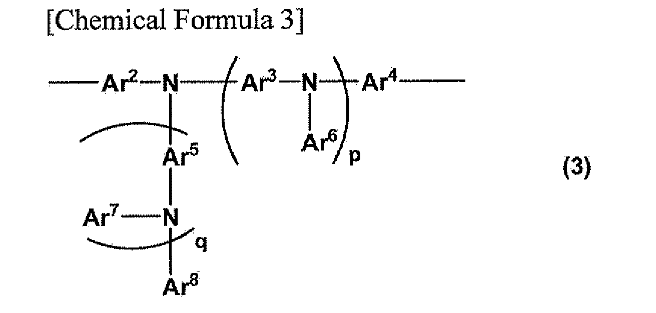 wherein in the formula (3), Ar², Ar³, Ar⁴ and Ar⁵ each independently represent an arylene group, a divalent aromatic heterocyclic group, or a divalent group where two or more identical or different groups selected from the group consisting of the arylene groups and the divalent aromatic heterocyclic groups are directly bonded, Ar⁶, Ar⁷ and Ar⁸ each independently represent an aryl group or a monovalent aromatic heterocyclic group, and p and q are each independently 0 or 1, provided that a group represented by Ar², Ar³, Ar⁴, Ar⁵, Ar⁶, Ar⁷ or Ar⁸ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, respectively, and a group represented by Ar⁵, Ar⁶, Ar⁷ or Ar⁸ may be bonded directly or through -O-, -S-, -C(=O)-, -C(=O)-O-, -N(R^{A})-, -C(=O)-N(R^{A})- or -C(R^{A})₂- to a group represented by Ar², Ar³, Ar⁴, Ar⁵, Ar⁶, Ar⁷ or Ar⁸ bonded to a nitrogen atom with the group bonded thereto to form a five- to seven-membered ring, respectively, wherein R^{A} represents an alkyl group, an aryl group, a monovalent aromatic heterocyclic group or an aralkyl group.

4. The metal complex composition according to claim 3, wherein the polymer compound includes, as the constitutional unit represented by the formula (2), a constitutional unit represented by the following formula (4): 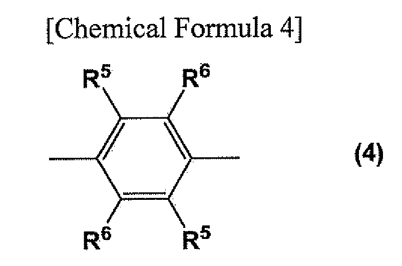 wherein in the formula (4), R⁵ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group or a cyano group, and R⁶ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that two R⁶S may be identical or different, and two R⁵s may be identical or different.

5. The metal complex composition according to claim 3 or 4, wherein the polymer compound includes, as the constitutional unit represented by the formula (2), a constitutional unit represented by the following formula (5): 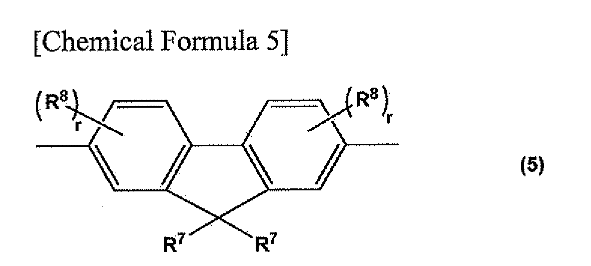 wherein in the formula (5), R⁷ represents an alkyl group, an aryl group, a monovalent aromatic heterocyclic group or an aralkyl group, R⁸ represents an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, and r represents an integer of 0 to 3, provided that two R⁷s may be identical or different, and two R⁷s may be bonded to form a ring structure, that when a plurality of R⁸s are present, the plurality of R⁸s may be identical or different, and that two rs may be identical or different.

6. The metal complex composition according to any one of claims 3 to 5, wherein the polymer compound is a conjugated polymer compound.

7. The metal complex composition according to any one of claims 3 to 6, further comprising an electron transport material having a structure represented by the following formula (6): 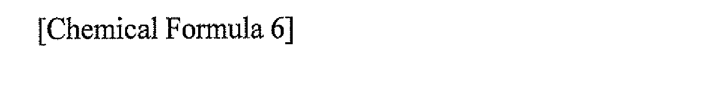 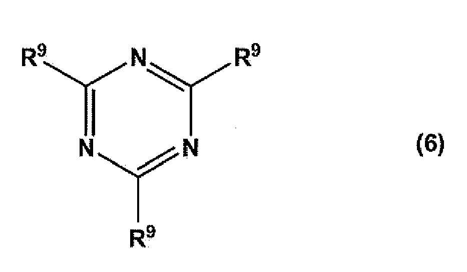 wherein in the formula (6), R⁹ represents a hydrogen atom, an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group, provided that three R⁹s may be identical or different.

8. A complex polymer comprising:
a divalent group that is a residue where two hydrogen atoms are removed from a metal complex including a structure represented by the following formula (1); and
at least one constitutional unit selected from the group consisting of a constitutional unit represented by the following formula (2) and a constitutional unit represented by the following formula (3), 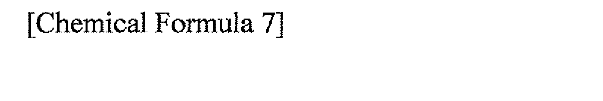 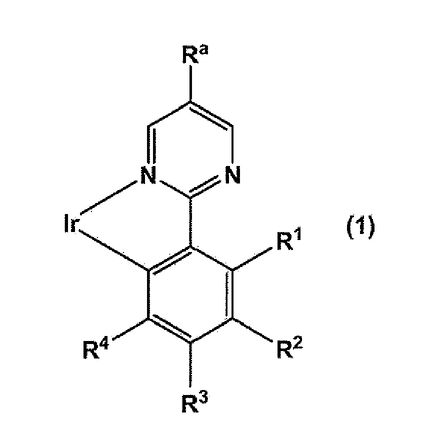 wherein in the formula (1), R^{a} represents an alkyl group having 2 to 30 carbon atoms that may have a substituent, and R¹, R², R³ and R⁴ each independently represent a hydrogen atom, an alkyl group having 1 to 30 carbon atoms that may have a substituent, an aryl group having 6 to 60 carbon atoms that may have a substituent, an alkenyl group having 2 to 30 carbon atoms that may have a substituent, an alkynyl group having 2 to 30 carbon atoms that may have a substituent, an amino group having 0 to 30 carbon atoms that may have a substituent, a heterocyclic group having 1 to 60 carbon atoms that may have a substituent, an alkoxy group having 1 to 30 carbon atoms that may have a substituent, an alkylthio group having 1 to 30 carbon atoms that may have a substituent, an aryloxy group having 6 to 60 carbon atoms that may have a substituent, an arylthio group having 6 to 60 carbon atoms that may have a substituent, a heterocyclic oxy group having 1 to 60 carbon atoms that may have a substituent, a heterocyclic thio group having 1 to 60 carbon atoms that may have a substituent, an acyl group, an acyloxy group, an amide group, an acid imide group, an imine residue, a substituted silyl group, a substituted silyloxy group, a substituted silylthio group, a substituted silylamino group, a halogen atom, a cyano group, a carboxyl group or a trifluoromethyl group, provided that adjacent groups among R¹, R², R³ and R⁴ may be bonded to each other to form a ring structure,
[Chemical Formula 8] -Ar¹- (2)
wherein in the formula (2), Ar¹ represents an arylene group, a divalent aromatic heterocyclic group, or a divalent group where two or more identical or different groups selected from the group consisting of the arylene groups and the divalent aromatic heterocyclic groups are directly bonded, provided that a group represented by Ar¹ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, 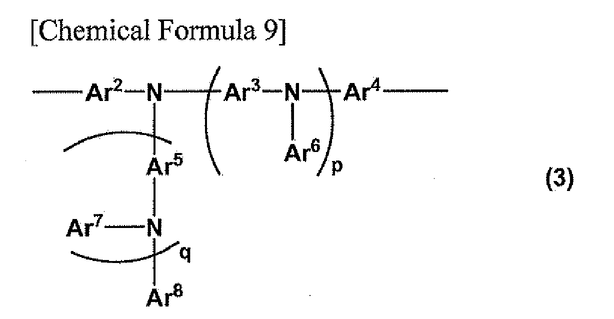 wherein in the formula (3), Ar², Ar³, Ar⁴ and Ar⁵ each independently represent an arylene group, a divalent aromatic heterocyclic group, or a divalent group where two or more identical or different groups selected from the group consisting of the arylene groups and the divalent aromatic heterocyclic groups are directly bonded, Ar⁶, Ar⁷ and Ar⁸ each independently represent an aryl group or a monovalent aromatic heterocyclic group, and p and q are each independently 0 or 1, provided that a group represented by Ar², Ar³, Ar⁴, Ar⁵, Ar⁶, Ar⁷ or Ar⁸ may have an alkyl group, an aryl group, a monovalent aromatic heterocyclic group, an alkoxy group, an aryloxy group, an aralkyl group, an arylalkoxy group, a substituted amino group, a substituted carbonyl group, a substituted carboxyl group, a fluorine atom or a cyano group as a substituent, respectively, and a group represented by Ar⁵, Ar⁶, Ar⁷ or Ar⁸ may be bonded directly or through -O-, -S-, -C(=O)-, -C(=O)-O-, -N(R^{A})-, -C(=O)-N(R^{A})- or -C(R^{A})₂- to a group represented by Ar², Ar³, Ar⁴, Ar⁵, Ar⁶, Ar⁷ or Ar⁸ bonded to a nitrogen atom with the group bonded thereto to form a five- to seven-membered ring, respectively, wherein R^{A} represents an alkyl group, an aryl group, a monovalent aromatic heterocyclic group or an aralkyl group.

9. A liquid composition comprising:
the metal complex composition according to any one of claims 1 to 7 or the complex polymer according to claim 8; and
a solvent.

10. An organic film comprising the metal complex composition according to any one of claims 1 to 7 or the complex polymer according to claim 8.

11. An organic electroluminescence device comprising an organic film, the organic electroluminescence device comprising the metal complex composition according to any one of claims 1 to 7 or the complex polymer according to claim 8 in the organic film.

12. A planar light source comprising the organic electroluminescence device according to claim 11.

13. A display comprising the organic electroluminescence device according to claim 11.
